# EUROPÄISCHE PATENTSCHRIFT

(11) **EP 2 959 520 B1**
(45) Veröffentlichungstag und Bekanntmachung des Hinweises auf die Patenterteilung: **01.02.2017**
(21) Anmeldenummer: 14709574.9
(22) Anmeldetag: 21.02.2014
(51) Int. Cl.: H01L 51/42

(54) **OPTOELEKTRONISCHES BAUELEMENT**
OPTOELECTRONIC COMPONENT
COMPOSANT OPTOÉLECTRONIQUE

(30) Priorität: 21.02.2013 DE 102013101715; 19.09.2013 DE 102013110373
(43) Veröffentlichungstag der Anmeldung: 30.12.2015
(73) Patentinhaber: Heliatek GmbH, 01139 Dresden (DE)
(72) Erfinder: WALZER, Karsten, 01099 Dresden (DE); PFEIFFER, Martin, 01309 Dresden (DE); WEISS, Andre, 89081 Ulm (DE); UHRICH, Christian, 01307 Dresden (DE); LEVICHKOVA, Marieta, 01129 Dresden (DE); MATTERSTEIG, Gunter, 89075 Ulm (DE)
(86) Internationale Anmeldenummer: PCT/EP2014/053479
(87) Internationale Veröffentlichungsnummer: WO 2014/128278

(56) Entgegenhaltungen:
- US-A1- 2013 140 527
- ALMANTAS PIVRIKAS ET AL: "Influence of processing additives to nano-morphology and efficiency of bulk-heterojunction solar cells: A comparative review", SOLAR ENERGY, Bd. 85, Nr. 6, 21. Dezember 2010 (2010-12-21), Seiten 1226-1237, XP028212828, ISSN: 0038-092X, DOI: 10.1016/J.SOLENER.2010.10.012 [gefunden am 2010-11-22]
- CHRISTOPH J. BRABEC ET AL: "Influence of blend microstructure on bulk heterojunction organic photovoltaic performance", CHEMICAL SOCIETY REVIEWS, Bd. 40, Nr. 3, 16. November 2010 (2010-11-16), Seite 1185, XP055113539, ISSN: 0306-0012, DOI: 10.1039/c0cs00045k
- HSIANG-YU CHEN ET AL: "Fast-Grown Interpenetrating Network in Poly(3-hexylthiophene): Methanofullerenes Solar Cells Processed with Additive", JOURNAL OF PHYSICAL CHEMISTRY C, Bd. 113, Nr. 18, 7. Mai 2009 (2009-05-07), Seiten 7946-7953, XP055113556, ISSN: 1932-7447, DOI: 10.1021/jp810798z
- PEET J ET AL: "Method for increasing the photoconductive response in conjugated polymer/fullerene composites", APPLIED PHYSICS LETTERS, AMERICAN INSTITUTE OF PHYSICS, US, Bd. 89, Nr. 25, 18. Dezember 2006 (2006-12-18), Seiten 252105-252105, XP012087741, ISSN: 0003-6951, DOI: 10.1063/1.2408661
- HARALD HOPPE ET AL: "Morphology of polymer/fullerene bulk heterojunction solar cells", JOURNAL OF MATERIALS CHEMISTRY, ROYAL SOCIETY OF CHEMISTRY, GB, Bd. 16, Nr. 1, 1. Januar 2006 (2006-01-01) , Seiten 45-61, XP002599967, ISSN: 0959-9428, DOI: 10.1039/B510618B [gefunden am 2005-11-28]

## Beschreibung

Die Erfindung betrifft ein optoelektronisches Bauelement mit einer photoaktiven Schicht, welche zwischen einer Elektrode und einer Gegenelektrode angeordnet ist.

Optoelektronische Bauelemente, wie etwa Solarzellen oder LED's, TFT's, etc. finden heute eine breite Anwendung im alltäglichem sowie industriellem Umfeld.

So sind beispielsweise Dünnschicht-Solarzellen bekannt, welche eine flexible Ausgestaltung aufweisen und damit eine Anordnung auf gekrümmten Oberflächen erlauben. Solche Solarzellen weisen dabei bevorzugt aktive Schichten aus amorphen Silicium (a-Si) oder CIGS (Cu(In,Ga)(S,Se)₂) auf.

Nachteilig bei diesen Dünnschicht-Solarzellen sind die vor allem durch die Materialien bedingten hohen Produktionskosten.

Weiterhin bekannt sind auch Solarzellen mit organischen aktiven Schichten, welche flexibel ausgestaltet sind (Konarka - Power Plastic Series). Die organischen aktiven Schichten können dabei aus Polymeren (z.B. US7825326 B2) oder kleinen Molekülen (z.B. EP 2385556 A1) aufgebaut sein. Während Polymere sich dadurch auszeichnen, dass diese nicht verdampfbar und daher nur aus Lösungen aufgebracht werden können, sind kleine Moleküle verdampfbar.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm⁻¹), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie. Ein weiterer Vorteil liegt in der Möglichkeit, transparente Bauelemente herstellen zu können, welche beispielsweise in Glasapplikationen eingesetzt werden können.

Eine Solarzelle wandelt Lichtenergie in elektrische Energie um. Der Begriff photoaktiv bezeichnet bei Solarzellen die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen.

Eine in der Literatur bereits vorgeschlagene Realisierungsmöglichkeit einer organischen Solarzelle besteht in einer pin -Diode mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei oder mehr Materialien (sogenannte interpenetrierende Netzwerke bzw. bulk-heterojunction) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich <450nm liegt, vorzugsweise bei <400nm.

Möglichkeiten zur Anpassung der LUMO-Niveaus bzw. der HOMO-Niveaus sind dem Fachmann bekannt, wobei sehr viele organische Materialien mit unterschiedlichen Lagen der Energieniveaus der HOMOs und LUMOs bekannt sind. Die Anpassung erfolgt daher derart, dass ein Material ausgewählt und verwendet wird, welches über die gewünschten Lage der Energieniveaus des HOMO bzw. LUMO verfügt. Weiterhin können z.B. durch den Einbau von elektronenziehenden bzw. elektronenschiebenden Gruppen die HOMO- und LUMO-Niveaus von organischen Materialien gesenkt bzw. erhöht werden und somit die Anpassung eines Materials entsprechend den Anforderungen erfolgen.

Da durch das Licht immer erst Exzitonen erzeugt werden und noch keine freien Ladungsträger, spielt die rekombinationsarme Diffusion von Exzitonen an die aktive Grenzfläche eine kritische Rolle bei organische Solarzellen. Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Bisher sind im Bereich der kleinen Moleküle die Absorber-Schichtdicken auf ca. 30-40 nm (im besten Fall 60 nm) limitiert, wogegen im Polymerbereich bis zu 200 nm bei weiterhin guten Füllfaktor (FF)(>60%) möglich sind. Hintergrund ist der schlechtere Ladungsträgertransport in SM-OPV (organische Solarzellen mit kleinen Molekülen), da es im Gegensatz zu Polymeren on-chain Transport nicht gibt. Im Bereich der organischen Solarzellen mit kleinen Molekülen wurde das Problem bisher durch immer höhere Extinktionskoeffizienten (in Lösung bis 100.000 und darüber), welche zu guten Effizienzen bei gutem FF geführt haben, gelöst. Aufgrund des Cyaninlimits ist dies aber nicht endlos steigerungsfähig. Daher werden Lösungen gesucht, wie man Donor-Akzeptor-Mischschichten (sogenannte bulk heterojunctions, BHJ) dicker machen kann, um die Quantenausbeute zu erhöhen. A. Pivrikas et al. beschreiben in Solar Energy, 85(6), 1226-1237 die Morphologie von aktiven Fotoschicht von bulk hetero-junction (BHJ) Solarzellen. Im Abschnitt 6 wird beschrieben, wie die Morphologie der aktiven Fotoschicht durch Zugabe von Additiven beeinflusst und dadurch die elektrischen Parameter der Solarzellen verbessert werden können. Die aktiven Fotoschichten der BHJ-Solarzellen umfassen im Allgemeinen P3HT und PCBM als aktive Materialien. Die Additive umfassen u.a. Triphenylamine, LiCF₃SO₃, 1,8-Diiodooktan, Nitrobenzen, 1- Chloronaphthalen und Thiole.

H.-Y. Chen et al, J. Phys. Chem C, 113(18), 7946-7953; J. Peet et al., Appl. Phys. Let., 89(25), 252105 und US 2013/140527 beschreiben die Verwendung von Thiolen als Additive um das Kristallisationsverhalten der aktiven Materialien von BHJ-Solarzellen zu beeinflussen.

Die Aufgabe der vorliegenden Erfindung besteht daher darin, ein optoelektronisches Bauelement sowie ein Verfahren zur Herstellung eines optoelektronischen Bauelements anzugeben, welches eine verbesserte Quantenausbeute aufweist.

Die Aufgabe wird durch ein optoelektronisches Bauelement nach Anspruch 1 gelöst. Vorteilhafte Ausgestaltungen sind in den abhängigen Ansprüchen angegeben.

Eine erhöhte Quantenausbeute könnte durch eine Erhöhung der Schichtdicke der photoaktiven Schicht erzielt werden. Problematisch dabei ist jedoch die auftretende Torsion der Oligomerbausteine sowie eine zu starke Kristallisation, welche oft Kurzschlüsse verursacht.

Erfindungsgemäß wird daher ein optoelektronisches Bauelement umfassend zumindest eine photoaktive Schicht vorgeschlagen, wobei die photoaktive Schicht eine Mehrfach-Mischschicht enthaltend mindestens drei Materialien umfasst, wobei zumindest ein organisches Material aus kleinen Molekülen ist, wobei zumindest ein Material ein Donor und zumindest ein Material ein Akzeptor ist, wobei der Donor und der Akzeptor ein Donor-Akzeptor-System bilden mit zumindest einem dritten Material, welches so ausgebildet ist, dass es die Kristallisationsneigung des Donors und/oder Akzeptors beeinflusst.

Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere können diese kleinen Moleküle auch photoaktiv sein, wobei unter photoaktiv verstanden wird, dass die Moleküle unter Energiezufuhr ihren Ladungszustand ändern. Unter Energiezufuhr wird dabei sowohl Lichtenergiezufuhr, beispielsweise sichtbares Licht, UV-Licht oder aber auch elektrische Energiezufuhr verstanden.

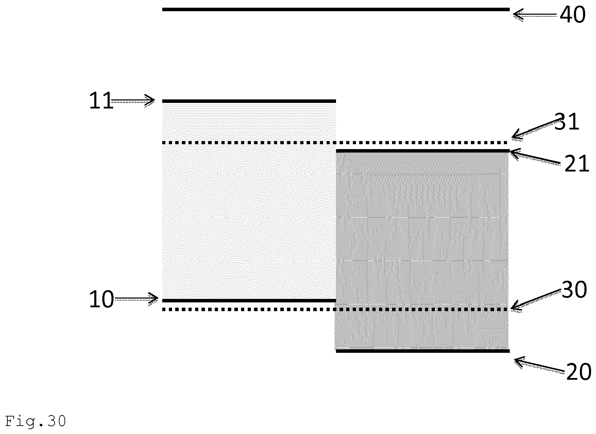

In einer Ausführungsform der Erfindung weist das dritte Material ein Energieniveau, bei dem der Betrag des LUMO <= dem LUMO des Akzeptors ist, und das HOMO betragsmäßig >= dem HOMO des Donors ist, auf. Die Differenz von HOMO und LUMO des dritten Materials ist daher größer als oder mindestens gleich groß wie die Differenz zwischen dem HOMO des Donors und dem LUMO des Akzeptors, gemäß Fig. 30.

Die Begriffe "HOMO" und "LUMO" werden wie in der Chemie üblich als highest occupied molecular orbital und lowest unoccupied molecular orbital verstanden. Der Begriff bezieht sich dabei sowohl auf einzelne Moleküle als auch auf Festkörper bzw. Materialfilme. Die Bestimmung der Energielagen von HOMO und LUMO kann dabei wie dem Fachmann bekannt z.B. über zyklische Voltametrie (CV) oder *Ultraviolett*-Photoelektronenspektroskopie (ultraviolet photoelectron spectroscopy UPS) erfolgen.

In einer weiteren Ausführungsform der Erfindung weist das dritte Material ein Energieniveau auf, wobei bevorzugt der Betrag des LUMO des dritten Materials um 0,3 eV geringer als das LUMO des Akzeptormaterials der photoaktiven Schicht und/oder der Betrag des HOMO des dritten Materials um 0,3 eV oberhalb des Betrags des Energieniveaus des HOMO des Donatormaterials der photoaktiven Schicht liegt.

In einer weiteren Ausführungsform der Erfindung ist der Anteil des dritten Materials in der photoaktiven Schicht < 10%.

In einer weiteren Ausführungsform der Erfindung ist der Anteil des dritten Materials in der photoaktiven Schicht zwischen 10% bis 50%.

In einer weiteren Ausführungsform der Erfindung ist der Anteil des dritten Materials in der photoaktiven Schicht 0,1 Gew.% < x < 30 Gew.%, bevorzugt 0,1 Gew.% < x < 20 Gew.%, besonders bevorzugt 0,1 Gew.% < x < 10 Gew.%.

In einer weiteren Ausführungsform der Erfindung verbessert das dritte Material gleichzeitig den Ladungstransport innerhalb der photoaktiven Schicht.

In einer weiteren Ausführungsform der Erfindung ist mindestens ein Donormaterial der photoaktiven Schicht ein Oligomer.

Unter Oligomeren werden im Sinne der Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen.

In einer weiteren Ausführungsform der Erfindung ist mindestens ein Donormaterial D1 der photoaktiven Schicht ein Oligomer, wobei der Betrag des HOMO des Donormaterials D1 gleich dem Betrag des HOMO des dritten Materials und der Betrag des LUMO des Donormaterials D1 gleich dem Betrag des LUMO des dritten Materials ist.

In einer weiteren Ausführungsform der Erfindung ist das dritte Material ein Oligomer.

In einer weiteren Ausführungsform der Erfindung ist das dritte Material so ausgebildet, dass eine Kristallisation von Donator und/oder Akzeptor vermieden wird. Dabei kann das dritte Material ein Lochleiter, ein Elektronenleiter oder ein ambipolar transportierendes Material sein, wobei letzteres z.B. auch eine Mischung aus Elektronen- und Lochleiter sein kann.

In einer weiteren Ausführungsform der Erfindung minimiert das dritte Material aufgrund seiner Molekularstruktur eine Kristallisation der Donator- und/oder Akzeptor-Phase. Durch die bessere Durchmischung von Donor und Akzeptor können mehr Exzitonen eine trennende Grenzfläche erreichen und in Ladungsträger getrennt werden und so zum Strom beitragen.

In einer weiteren Ausführungsform der Erfindung ist die Molekularstruktur des dritten Materials der molekularen Struktur des Donormaterials D1 weitgehend ähnlich, wodurch das dritte Material als Gitterdefekt im Donormaterial D1 wirkt, so dass das Donormaterial D1 nicht zu stark als reine Phase kristallisiert.

Als Gitterdefekt (auch Gitterfehler oder Kristallbaufehler) wird jede Unregelmäßigkeit in einem sonst periodischen Kristallgitter bezeichnet. Die Existenz von Gitterfehlern unterscheidet den realen Kristall vom theoretischen Modell des idealen Kristalls. Gitterfehler sind von grundlegender Bedeutung für viele Eigenschaften eines Kristalls, insbesondere für die chemische Reaktivität, Stofftransport und Diffusion im Kristall sowie für seine mechanischen Eigenschaften. Die Einteilung der Gitterdefekte erfolgt anhand der räumlichen Ausdehnung des Fehlergebietes. Man kennzeichnet die Zahl der räumlichen Dimensionen, in denen der Gitterdefekt mehr als atomare Ausdehnung besitzt. Auf diese Weise werden null- bis dreidimensionale Gitterdefekte unterschieden.

In einer Ausführungsform der Erfindung ist die molekulare Struktur des dritten Materials so ausgebildet, dass das dritte Material im Donor- und/oder Akzeptormaterial einen Gitterdefekt bewirkt.

In einer Ausführungsform der Erfindung ist die molekulare Struktur des dritten Materials der Struktur des Akzeptormaterials A1 weitgehend ähnlich, wodurch das dritte Material als Gitterdefekt im Akzeptormaterial A1 wirkt, so dass das Akzeptormaterial A1 nicht zu stark als reine Phase kristallisiert.

In einer weiteren Ausführungsform der Erfindung ist das dritte Material so ausgebildet, dass die Kristallisation von Donatormaterial und/oder Akzeptormaterial verbessert wird. In diesem Fall sorgt das dritte Material für eine Phasentrennung und verbessert damit den Ladungstransport in den einzelnen Phasen, indem geschlossenere Leitungspfade geschaffen werden. Die verbesserte Phasentrennung kann z.B. anhand eines verringerten Photolumineszenz-Signals der 3-fach Mischschicht gegenüber der ohne drittes Material nachgewiesen werden.

In einer weiteren Ausführungsform der Erfindung ist das dritte Material so ausgewählt, dass das dritte Material einen Mindest-Abstand zwischen dem Akzeptor und Donator einstellt, wobei das dritte Material gleichzeitig eine Phasenseparation des Akzeptors und Donators beiträgt. Damit kann das Problem der "geminalen Rekombination" verringert werden.

Unter geminaler Rekombination wird im Sinne der Erfindung die Rekombination bereits getrennter Ladungsträger mit sich selbst verstanden.

In einer weiteren Ausführungsform der Erfindung weist das dritte Material in seiner Molekülstruktur einen ersten Bereich auf, welcher fullerenophil ausgebildet ist und einen zweiten Bereich auf, welcher fullerenophob ausgebildet ist, wobei der erste und zweite Bereich räumlich getrennt ausgebildet sind.

Unter fullerenophil wird im Sinne der Erfindung eine Molekülstruktur oder zumindest ein Teil einer Molekülstruktur, die sich bevorzugt an Fullerene (C₆₀, C₇₀, etc.) anlagert.

Unter fullerenophob wird im Sinne der Erfindung eine Molekülstruktur oder zumindest ein Teil einer Molekülstruktur verstanden, welche sich bevorzugt nicht an Fullerene (C₆₀, C₇₀, etc.) anlagert.

In einer weiteren Ausführungsform der Erfindung weist das optoelektronische Bauelement zwischen der Elektrode und der Gegenelektrode mehr als eine photoaktive Schicht auf. Das Bauelement kann dabei etwa als Tandem- oder Triplezelle ausgebildet sein. Dies ist insbesondere vorteilhaft, da das einfallende Licht mehrere photoaktive Schichten innerhalb des Bauelements passiert. Besonders vorteilhaft sind die verschiedenen Absorberschichten aufeinander angepasst, wobei die Absorberschichten verschiedene Absorptionsmaxima aufweisen. Dies ermöglicht eine effiziente Nutzung des einfallenden Lichts.

In einer weiteren Ausführungsform der Erfindung umfasst mindestens eine der photoaktiven Schichten als Akzeptor ein Material aus der Gruppe der Fullerene bzw. Fullerenderivate.

In einer weiteren Ausführungsform der Erfindung ist zwischen der Elektrode und der Gegenelektrode zumindest eine dotierte, teilweise dotierte oder undotierte Transportschicht angeordnet.

In einer weiteren Ausführungsform der Erfindung ist das optoelektronische Bauelement zumindest in einem gewissen Lichtwellenlängenbereich semitransparent.

In einer weiteren Ausführungsform der Erfindung ist das optoelektronische Bauelement eine organische Solarzelle.

In einer weiteren Ausführungsform der Erfindung handelt es sich bei dem Bauelement um eine pin-Einzel, pin-Tandemzelle, pin-Mehrfachzelle, nip-Einzelzelle, nip- Tandemzelle oder nip-Mehrfachzelle.

In einer weiteren Ausführungsform der Erfindung besteht das Bauelement aus einer Kombination aus nip, ni, ip, pnip, pni, pip, nipn, nin, ipn, pnipn, pnin oder pipn-Strukturen, bei der mehrere unabhängige Kombinationen, die mindestens eine i-Schicht enthalten, übereinander gestapelt sind.

Das dritte Material ist ausgewählt aus der Gruppen Kronenether.

In einer weiteren Ausführungsform der Erfindung werden als drittes Material Kronenether der allgemeinen Formel (Ia und Ib) ausgewählt. 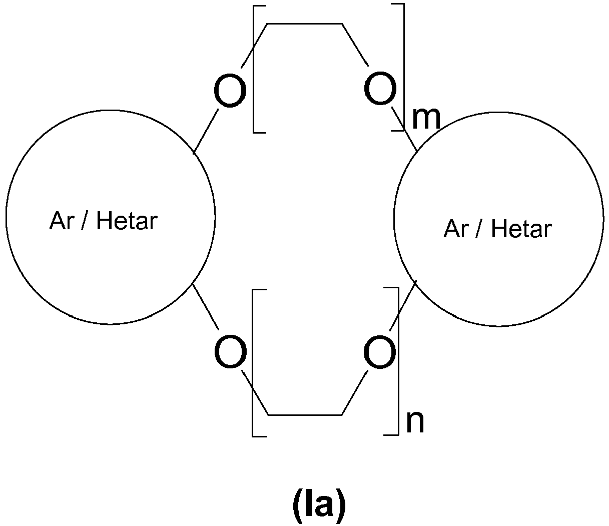 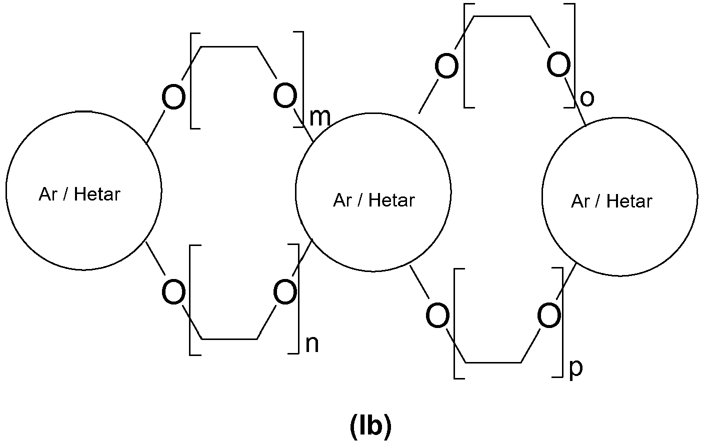
mit Ar = Phenyl, Biphenyl, Triphenyl, Naphthyl, Binaphthyl, 3-6 annelierte Phenylringe (z.B. Anthracenyl, Phenanthrenyl, Pyrenyl)
Hetar = Thiophen, Pyrrol, Furan, Oxazol, Thiazol, Oxadiazol, Thiadiazol, Triazol, Pyridin, Pyrimidin, Pyrazin, Benzothiophene, Benzopyrrol, Benzofuran, Benzothiophen, Benzopyrrol, Benzofuran, Benzoxazol, Benzothiazol,Thienothiophene, Thienopyrrol, Thienofuran, 3-6 annelierte Heterocyclen, Dithienothiophen, Dithienopyrrol, Dithienobenzol, Dithienocyclopentadiene, Dipyrrolobenzol Etherbrücken in 1,2-, 1,3- und 1,4-Verknüpfung am jeweiligen Phenylring (ortho, meta- und para-Position), Naphthylring, annelierten Phenylring sowie Heteroarylring und annelierten Heteroarylring.
m und n unabhängig voneinander 1,2,3,4,5,6
o und p unabhängig voneinander 0,1,2,3,4,5,6.

Insbesondere werden Dibenzo-Kronenether und Dinaphtho-Kronenether sowie gemischte Benzo-/Naphtho-Kronenether verwendet. Bevorzugt sind Verbindungen mit den nachfolgenden Strukturen: 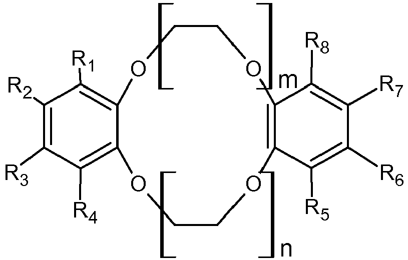 oder 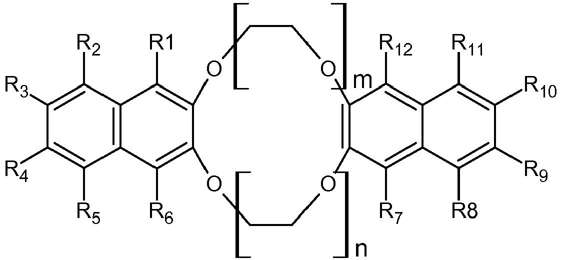 oder 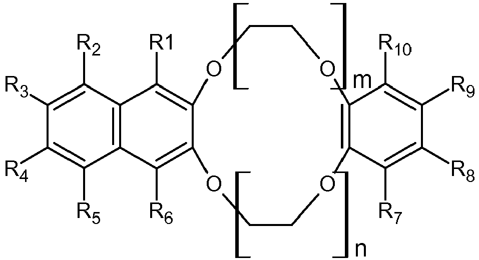 oder 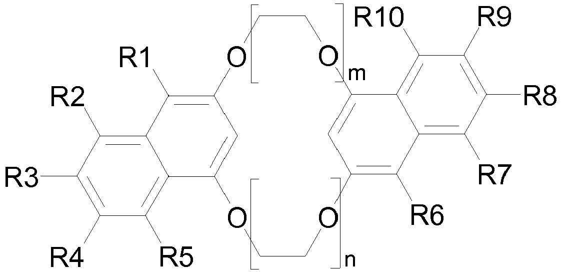 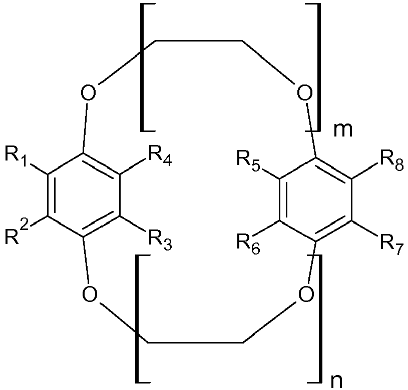 oder 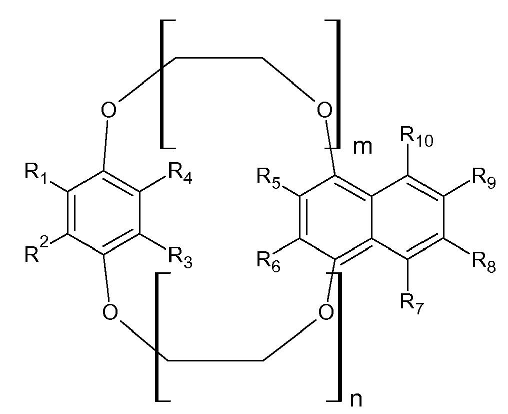 oder 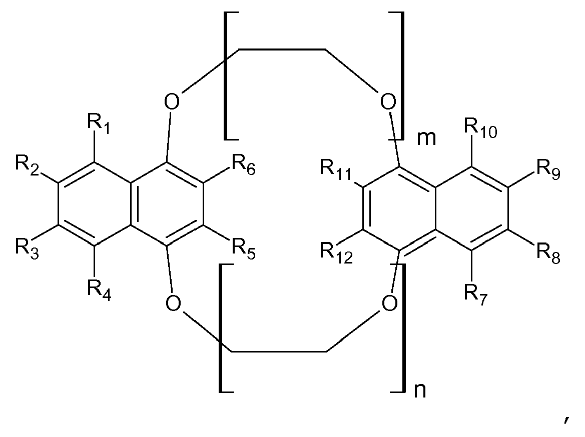
wobei jeweils gilt: n und m unabhängig voneinander ausgewählt aus 3, 4, oder 5, und
R₁, R₂, R₃, R₄, R₅, R₆, R₇, R₈, R₉, R₁₀, R₁₁ und R₁₂ unabhängig voneinander ausgewählt aus H, CH₃, C₂H₅, C₃H₇, C₄H₉, C₅H₁₁, C₆H₁₃, Isobutyl, CF₃, C₂F₅, C₃F₇, C₄F₉, C₅F₁₁, C₆F₁₃, OH, O-CH₃, CH₂-O-CH₃, CH₂-O-CH₂-CH₃, CN, Phenyl, Thiophen.

In einer Ausführungsform der Erfindung weisen die Kronenether die nachfolgende allgemeine Formel (II) auf: 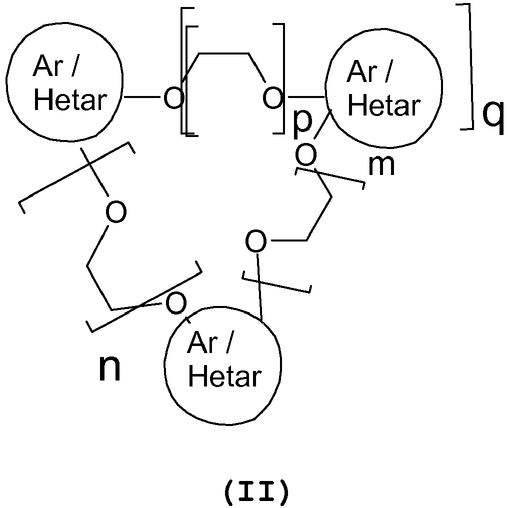
mit Ar = Phenyl, Naphtyl, Biphenyl, Triphenyl, Naphthyl, Binaphthyl, 3-6 annelierte Phenylringe, Anthracenyl, Phenanthrenyl, Pyrenyl,
Hetar = Thiophen, Pyrrol, Furan, Thienothiphene, Oxazol, Thiazol, Oxadiazol, Thiadiazol, Triazol, Pyridin, Pyrimidin, Pyrazin, Benzothiophene, Benzopyrrol, Benzofuran, Benzothiophen, Benzopyrrol, Benzofuran, Benzoxazol, Benzothiazol, Thienothiophene, Thienopyrrol, Thienofuran, 3-6 annelierte Heterocyclen, Dithienothiophen, Dithienopyrrol, Dithienobenzol, Dithienocyclopentadiene, Dipyrrolobenzol
   Etherbrücken in 1,2-, 1,3- und 1,4-Verknüpfung am jeweiligen Phenylring (ortho, meta- und para-Position), Naphthylring, annelierten Phenylring sowie Heteroarylring und annelierten Heteroarylring.
m und n unabhängig voneinander 1,2,3,4,5,6
p und q unabhängig voneinander 1,2,3,4,5,6

Besonders bevorzugt sind Verbindungen mit den nachfolgenden Strukturen:

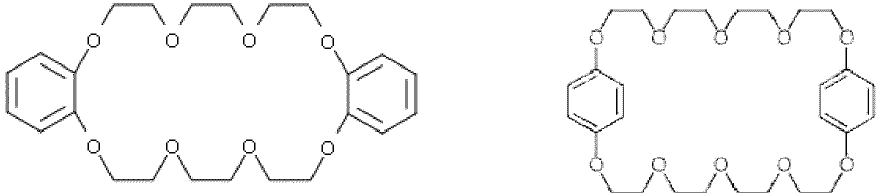

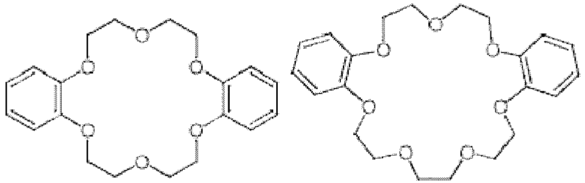

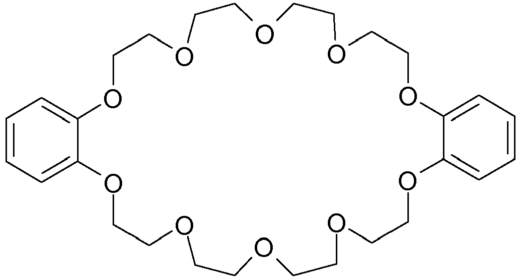

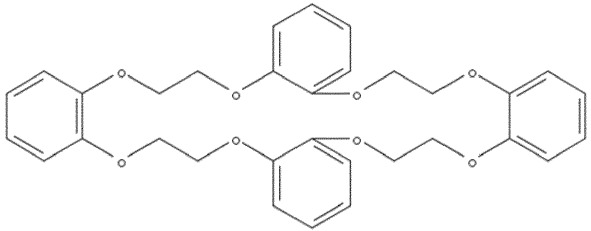

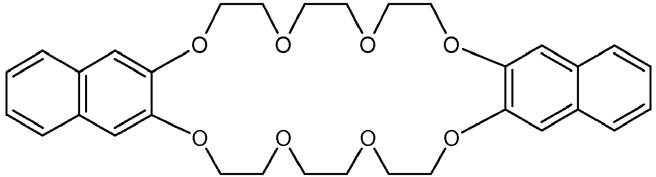

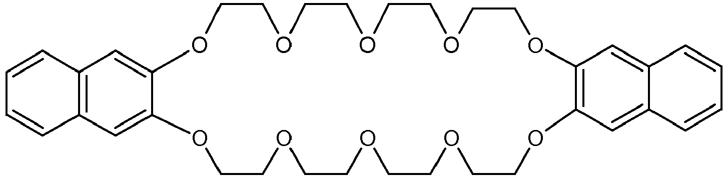

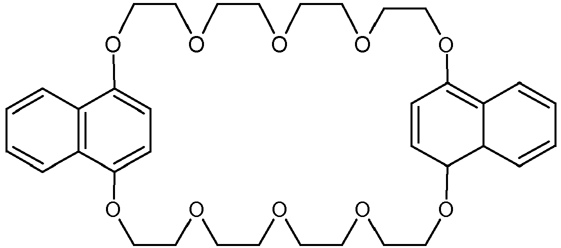

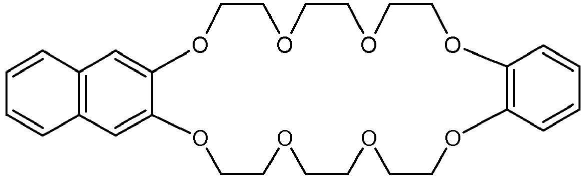

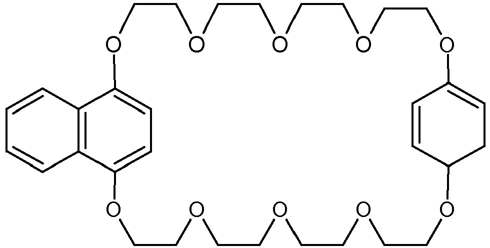

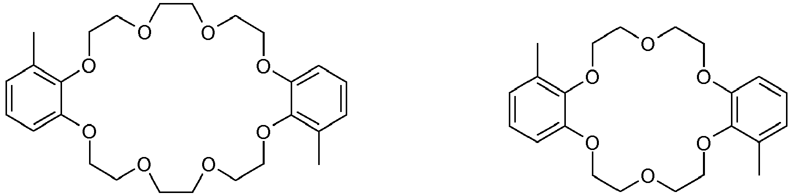

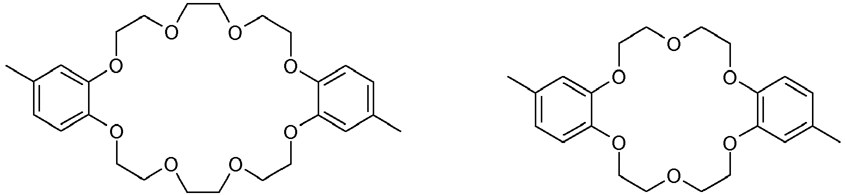

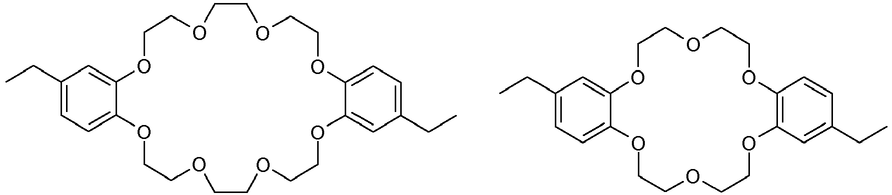

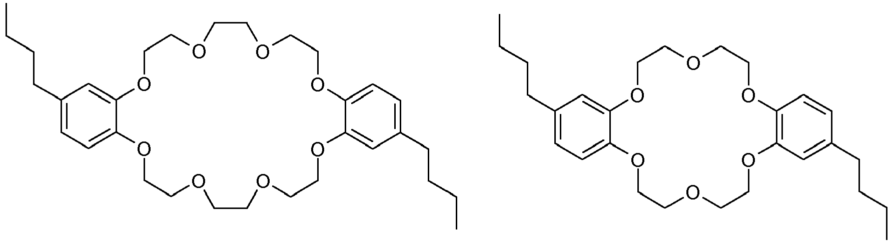

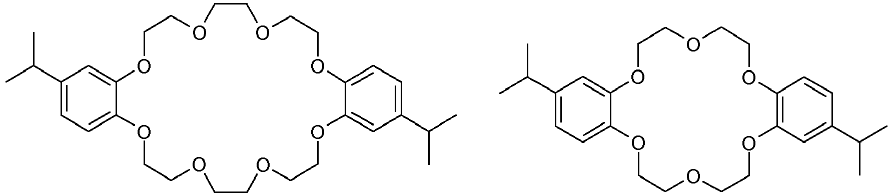

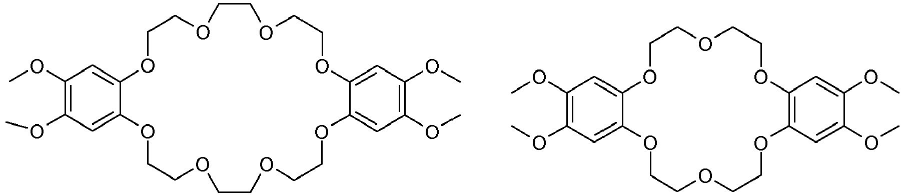

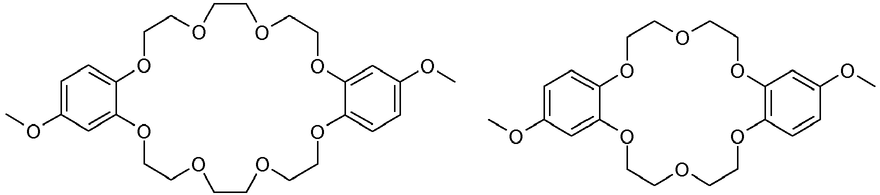

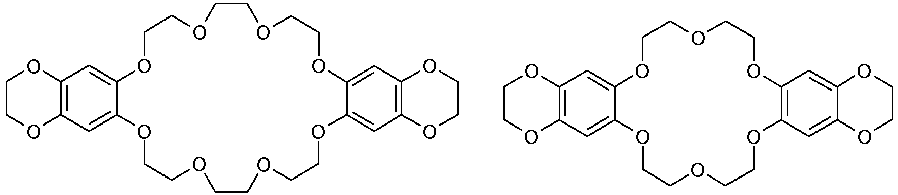

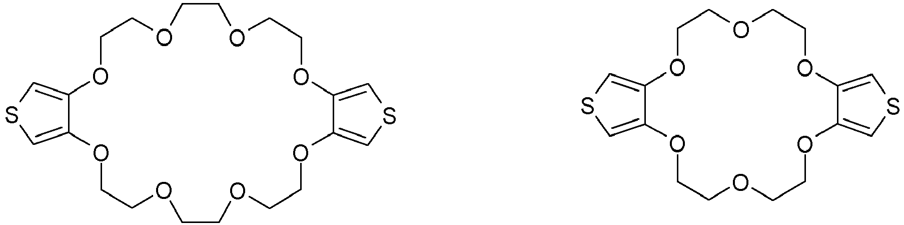

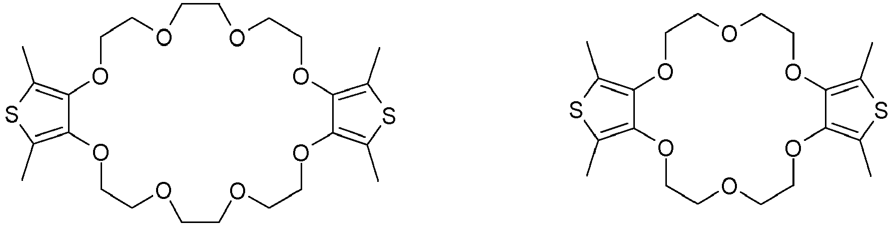

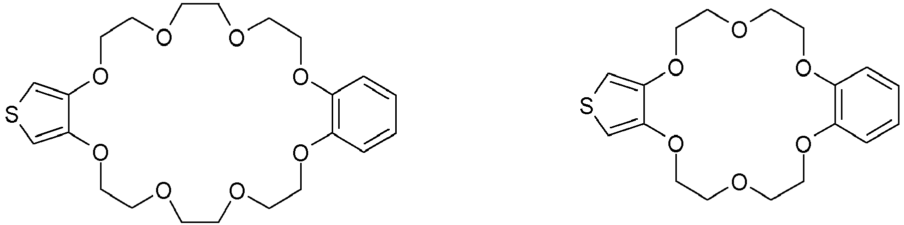

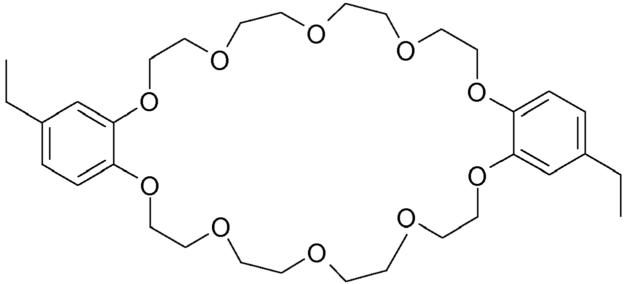

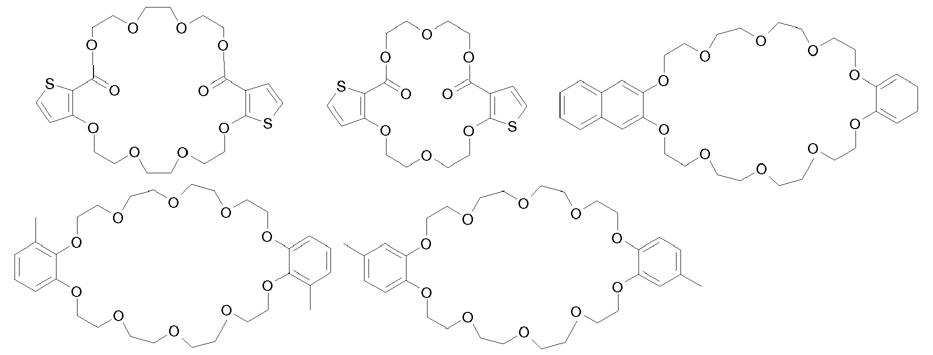

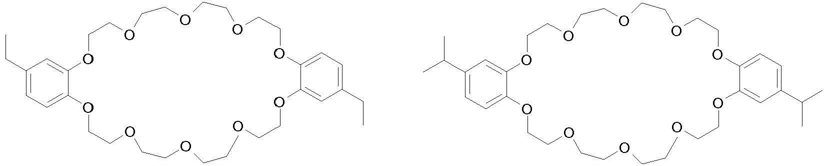

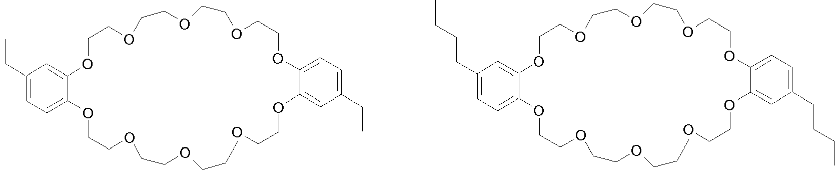

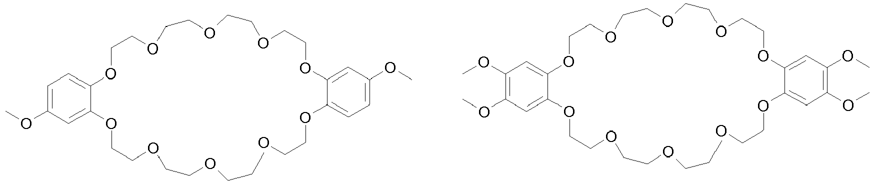

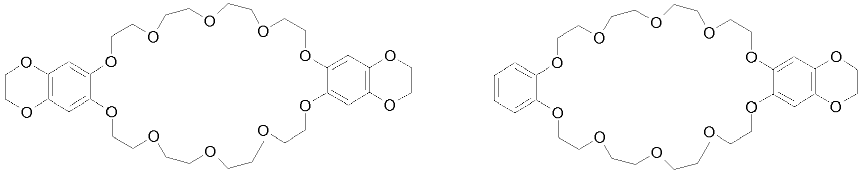

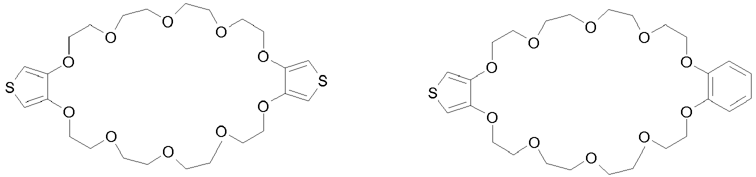

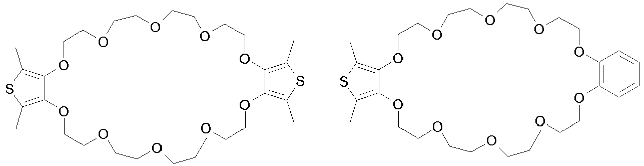

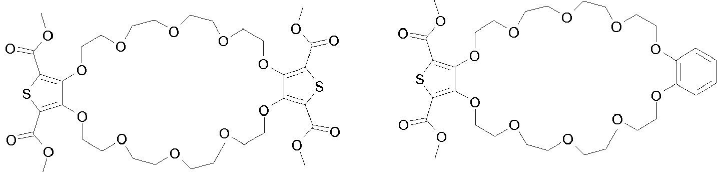

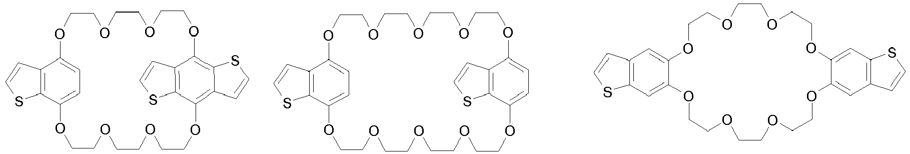

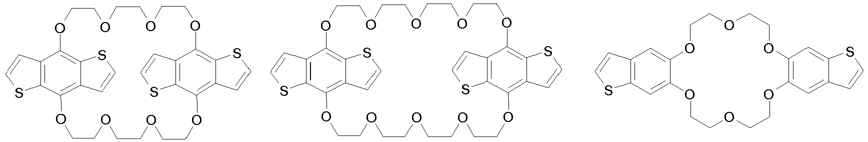

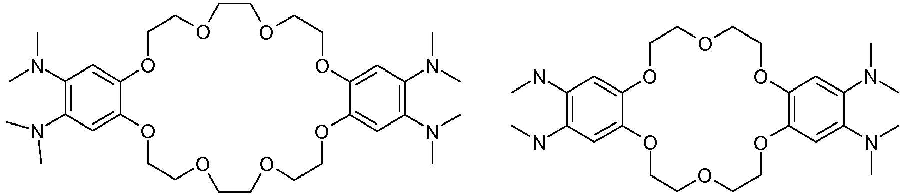

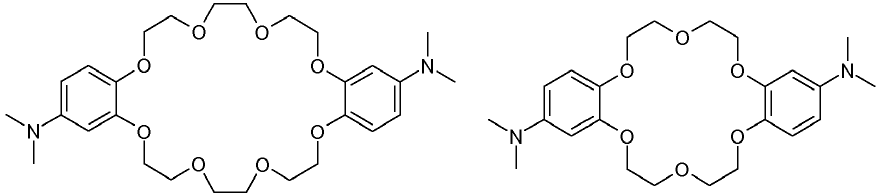

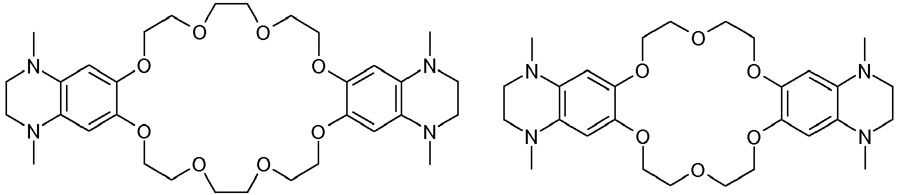

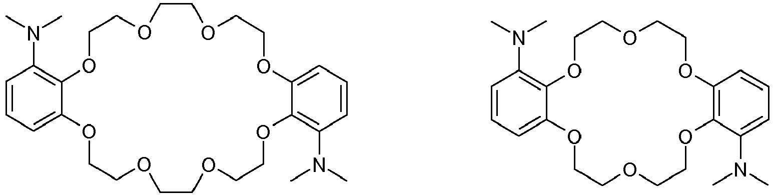

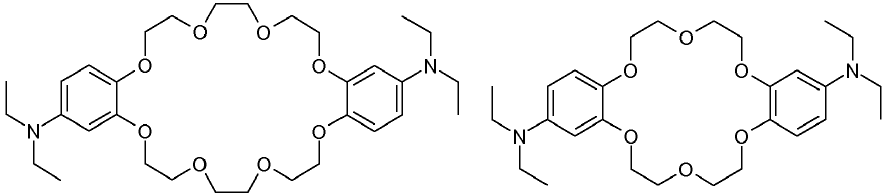

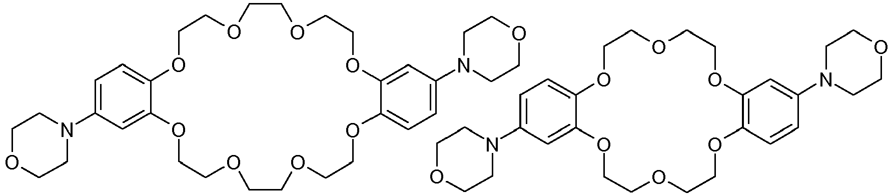

In einer Ausführungsform der Erfindung sind die Kronenether ausgewählt aus einer Gruppe bestehend aus Aryl- und Heteroaryl- Kronenethern sowie annelierten Aryl- und annelierten Heteroaryl-Kronenethern, bevorzugt Diaryl- und Diheteroaryl-Kronenethern sowie gemischt Aryl- und Heteroaryl-Kronenethern, besonders bevorzugt Dibenzo-Kronenether, Dinaphtho-Kronenether sowie gemischte Benzo-Naphthokronenether. Ein Aryl-Kronenether besteht aus mindestens einer Arylgruppe, kann aber auch eine bi-, tri- und polycyclische aromatische Kohlenwasserstoffgruppe besitzen. An diesem sind zwei C-Atome des Arylgrundgerüsts ringförmig mit Monoethoxy-, Diethoxy-, Triethoxy-, Tetraethoxy-, Pentaethoxy- und Hexaethoxygruppen verknüpft. Ein annelierter Aryl-Kronenether besteht aus mindestens einer bicyclischen aromatischen Kohlenwasserstoffgruppe, kann aber auch eine tri- und polycyclische aromatische Kohlenwasserstoffgruppe besitzen. An diesem sind zwei C-Atome des annelierten Grundgerüsts ringförmig mit Monoethoxy-, Diethoxy-, Triethoxy-, Tetraethoxy-, Pentaethoxy- und Hexaethoxygruppen verknüpft. Ein annelierter Heteroaryl-Kronenether besteht aus mindestens einem Heteroarylring, an dem mindestens ein Benzolring oder ein weiterer Heteroarylring anneliert sind, kann aber auch eine tri- und polycyclische heteroaromatische Kohlenwasserstoffgruppe besitzen. An diesem sind zwei C-Atome des annelierten Grundgerüsts ringförmig mit Monoethoxy-, Diethoxy-, Triethoxy-, Tetraethoxy-, Pentaethoxy- und Hexaethoxygruppen verknüpft. Ein Diaryl-Kronenether besteht aus zwei nicht annelierten (separaten) Arylgruppen, die über zwei Alkoxy-Brücken miteinander in Form einer Krone verknüpft sind. Diese Alkoxyeinheiten bestehen aus ein bis sechs Ethoxygruppen. Ein annelierter Diaryl-Kronenether besteht aus zwei annelierten Arylgruppen, die über zwei Alkoxy-Brücken miteinander in Form einer Krone verknüpft sind. Diese Alkoxyeinheiten bestehen aus ein bis sechs Ethoxygruppen. Ein annelierter Diheteroaryl-Kronenether besteht aus zwei annelierten Heteroarylgruppen, die über zwei Alkoxy-Brücken miteinander in Form einer Krone verknüpft sind. Diese Alkoxyeinheiten bestehen aus ein bis sechs Ethoxygruppen. Ein Aryl-Heteroaryl-Kronenether besteht sowohl aus einer Arylgruppe als auch einer Heteroarylgruppe, die über zwei Alkoxy-Brücken miteinander in Form einer Krone verknüpft sind. Diese Alkoxyeinheiten bestehen aus ein bis sechs Ethoxygruppen.

Bevorzugte Weiterbildungen der Erfindung ergeben sich aus den Kombinationen der Ansprüche oder einzelner Merkmale davon.

Nachfolgend soll die Erfindung anhand einiger Ausführungsbeispiele und Figuren eingehend erläutert werden. Die Ausführungsbeispiele sollen dabei die Erfindung beschreiben ohne diese zu beschränken. Es zeigen in
Fig. 1 eine schematische Darstellung eines erfindungsgemäßen Bauelements, in
Fig. 2 eine Strom-Spannungskennlinie eines Vergleich-Bauelements mit zwei Materialien in der photoaktiven Schicht, in
Fig. 3 eine Strom-Spannungskennlinie eines Bauelements mit gleichem Schichtaufbau wie in Fig. 2 dargestellt, jedoch mit drei Materialien in der photoaktiven Schicht, wobei als drittes Material Verbindung (I) verwendet wird, in
Fig. 4 eine Strom-Spannungskennlinie eines Vergleich-Bauelements mit zwei Materialien in der photoaktiven Schicht, in
Fig. 5 eine Strom-Spannungskennlinie eines Bauelements mit gleichem Schichtaufbau wie in Fig. 4 dargestellt, jedoch mit drei Materialien in der photoaktiven Schicht, wobei als drittes Material Verbindung (I) verwendet wird, in
Fig. 6 eine Strom-Spannungskennlinie eines Vergleich-Bauelements mit zwei Materialien in der photoaktiven Schicht, in
Fig. 7 eine Strom-Spannungskennlinie eines Bauelements mit gleichem Schichtaufbau wie in Fig. 6 dargestellt, jedoch mit drei Materialien in der photoaktiven Schicht, wobei als drittes Material Verbindung (I) verwendet wird, in
Fig. 8 eine Strom-Spannungskennlinie eines Vergleich-Bauelements mit zwei Materialien in der photoaktiven Schicht, in
Fig. 9 eine Strom-Spannungskennlinie eines Bauelements mit gleichem Schichtaufbau wie in Fig. 8 dargestellt, jedoch mit drei Materialien in der photoaktiven Schicht, wobei als drittes Material Verbindung (II) verwendet wird, in
Fig. 14 eine Strom-Spannungskennlinie eines Vergleich-Bauelements mit zwei Materialien in der photoaktiven Schicht, abgeschieden bei 70°C Substrattemperatur, in
Fig. 15 eine Strom-Spannungskennlinie eines Bauelements mit gleichem Schichtaufbau wie in Fig. 14 dargestellt, jedoch mit drei Materialien in der photoaktiven Schicht, wobei als drittes Material Verbindung (III) verwendet wird und die Abscheidung bei Raumtemperatur erfolgte, in
Fig. 16 eine Strom-Spannungskennlinie eines Vergleich-Bauelements mit zwei Materialien in der photoaktiven Schicht, abgeschieden bei 70°C Substrattemperatur und in
Fig. 17 eine Strom-Spannungskennlinie eines Bauelements mit gleichem Schichtaufbau wie in Fig. 16 dargestellt, jedoch mit drei Materialien in der photoaktiven Schicht, wobei als drittes Material Verbindung (I) verwendet wird und die Abscheidung bei Raumtemperatur erfolgte,
Fig. 18 eine Strom-Spannungskennlinie eines Vergleich-Bauelements mit zwei Materialien in der photoaktiven Schicht, abgeschieden bei 70°C Substrattemperatur, in
Fig. 19 eine Strom-Spannungskennlinie eines Bauelements mit gleichem Schichtaufbau wie in Fig. 18 dargestellt, jedoch mit drei Materialien in der photoaktiven Schicht, wobei als drittes Material Verbindung (VI) verwendet wird und die Abscheidung bei Raumtemperatur erfolgte, in
Fig. 20 eine Strom-Spannungskennlinie eines Vergleich-Bauelements mit zwei Materialien in der photoaktiven Schicht, in
Fig. 21 eine Darstellung der externen Quanteneffizienz eines Vergleich-Bauelements mit zwei Materialien in der photoaktiven Schicht, in
Fig. 22 eine Darstellung des Füllfaktorverhaltens und der Leerlaufspannung eines Vergleich-Bauelements mit zwei Materialien in der photoaktiven Schicht in Abhängigkeit der Lichteinstrahlung, in
Fig. 23 eine Strom-Spannungskennlinie eines erfindungsgemäßen Bauelements mit drei Materialien in der photoaktiven Schicht, in
Fig. 24 eine Darstellung der externen Quanteneffizienz eines Bauelements mit drei Materialien in der photoaktiven Schicht, in
Fig. 25 eine Darstellung des Füllfaktorverhaltens und der Leerlaufspannung eines erfindungsgemäßen Bauelements mit drei Materialien in der photoaktiven Schicht in Abhängigkeit der Lichteinstrahlung, in
Fig. 26 eine Strom-Spannungskennlinie eines Vergleich-Bauelements mit zwei Materialien in der photoaktiven Schicht, in
Fig. 27 eine Darstellung der externen Quanteneffizienz eines Vergleich-Bauelements mit zwei Materialien in der photoaktiven Schicht, in
Fig. 28 eine Strom-Spannungskennlinie eines erfindungsgemäßen Bauelements mit drei Materialien in der photoaktiven Schicht, in
Fig. 29 eine Darstellung der externen Quanteneffizienz eines Bauelements mit drei Materialien in der photoaktiven Schicht und in
Fig. 30 eine schematische Darstellung eines Energieschemas mit drei Materialien.

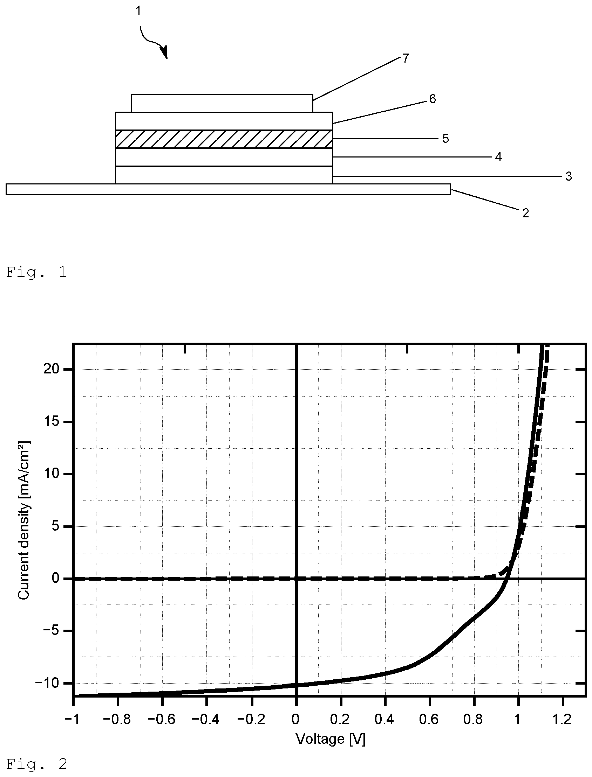

In einem Ausführungsbeispiel der Erfindung ist in Fig. 1 schematisch ein Bauelement 1 dargestellt, welches beispielsweise als organische Solarzelle ausgeführt ist. Das Bauelement 1 ist dabei auf einem transparenten Substrat 2 angeordnet, welches vorzugsweise flexibel ausgeführt ist, etwa als Folie. Auf dem Substrat 2 ist eine Elektrode 3 angeordnet, welche aus Metall, einem leitfähigen Oxid, insbesondere ITO, ZnO:Al oder anderen TCOs oder einem leitfähigen Polymer, wie etwa PEDOT:PSS oder PANI ausgeführt ist. Auf der Elektrode 3 ist eine Ladungsträgertransportschicht 4 angeordnet, welche beispielsweise als Elektronen- oder Löchertransportschicht ausgebildet ist. Auf dieser Ladungsträgertransportschicht 4 ist eine photoaktive Schicht 5 angeordnet, welche zumindest ein Donor- und ein Akzeptormaterial umfasst, welche zusammen ein Donor-Akzeptorsystem ausbilden. Zudem umfasst die photoaktive Schicht ein drittes Material mit einem Anteil von 0,1 Gew.% < x < 10 Gew.%. Dieses dritte Material ist ausgewählt aus einer Gruppe bestehend aus Kronenether, Triphenyle, Sorbitole, Chinacridone, Bis(4-(tert-butyl)benzoato-O)hydroxyaluminium. Auf der photoaktiven Schicht 5 ist eine weitere Ladungsträgertransportschicht 6 angeordnet. Diese Ladungsträgertransportschicht 6 ist ebenfalls als Elektronen- oder Löchertransportschicht ausgebildet, wobei die Ladungsträgertransportschicht 6 komplementär zur Ladungsträgertransportschicht 4 ausgebildet ist. Auf dieser Ladungsträgertransportschicht 6 ist eine Gegenelektrode 7 angeordnet, welche beispielsweise aus einem Metall, wie etwa Al ausgebildet ist.

In einem zweiten Ausführungsbeispiel weist das erfindungsgemäße Bauelement 1 eine photoaktive Schicht 5 auf, welche drei Materialien umfasst, wobei ein Donor- D1 und ein Akzeptormaterial Al ein Donorakzeptorsystem ausbilden. Das Donormaterial D1 ist dabei beispielsweise ein Material aus der Klasse der Phthalocyanine, Perylenderivate, TPD-Derivate, Oligothiophene oder ein Material wie es in WO2006092134 A1, WO2011161262 oder WO2011161170A1 offenbart ist. Das Akzeptormaterial A1 ist dabei beispielsweise ein Fulleren oder Fullerenderivat (C60, C70, etc.). Die photoaktive Schicht 5 enthält weiterhin ein drittes Material, welches als weiteres Donormaterial D2 ausgebildet ist. Das dritte Material D2 beeinflusst dabei die Kristallisationsneigung des Donormaterials D1. In einer alternativen Ausgestaltung ist das dritte Material ein Akzeptormaterial A2, welches die Kristallisationsneigung des Akzeptormaterials A1 beeinflusst.

In einem weiteren Ausführungsbeispiel weist das photoaktive Bauelement 1 beispielsweise die nachfolgende Struktur auf:
ITO / C60 / photoaktive Mischschicht / BPAPF (9,9-bis[4-(N,N-bis-biphenyl-4-yl-Amino)Phenyl]-9H-Fluoren) / BPAPF:NDP9 / NDP9 / Au
wobei die photoaktive Mischschicht als drittes Material eine der nachfolgenden Verbindungen in einer Beimischung von < 7% enthält:

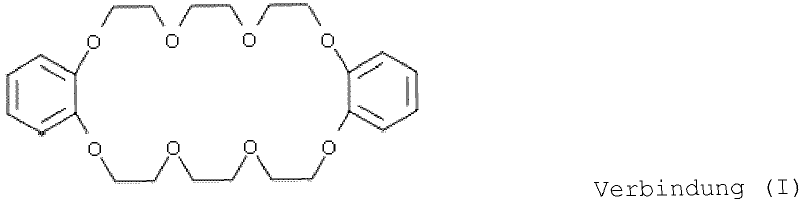

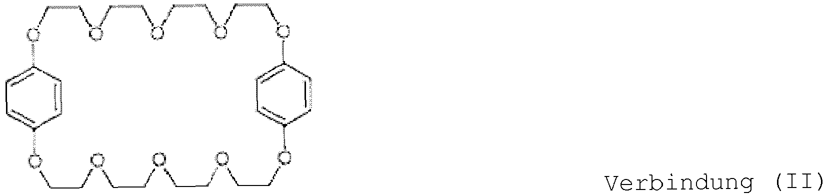

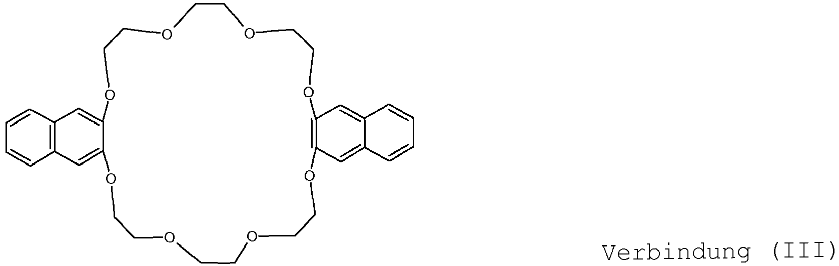

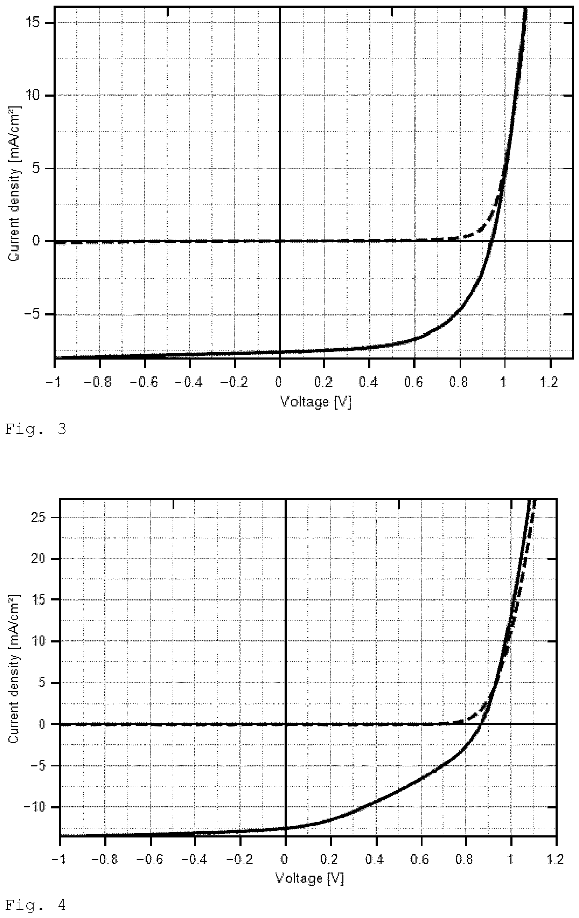

In einem weiteren Ausführungsbeispiel sind in den Fig. 2 und 3 graphisch die Messergebnisse für ein Bauelement 1 mit einer photoaktiven Schicht 5 mit einem Donor-Akzeptorsystem dargestellt, wobei die photoaktive Schicht 5 eine Schichtdicke von 30 nm aufweist. Die Abscheidung der photoaktiven Schicht 5 erfolgte bei einer Substrattemperatur von 70°C. Die Fig. 2 zeigt die Strom-Spannungskennlinie eines Bauelements 1 mit einem Donor-Akzeptorsystem und die Fig. 3 eine Strom-Spannungskennlinie für ein Bauelement mit einer photoaktiven Schicht enthaltend das Donor-Akzeptorsystem sowie Verbindung (I). Die photoaktive Schicht 5 der Bauelemente unterscheidet sich hierbei nur hinsichtlich der Beimischung der Verbindung (I). Dabei zeigt sich ein durch die Beimischung der Verbindung (I) bedingter Anstieg des Füllfaktors (FF) von 46% auf 58,6%.

Aus dem Vergleich der Füllfaktoren (FF) lässt sich ablesen, dass die Zugabe des dritten Materials einen wesentlichen Einfluss auf den erzeugten Strom hat.

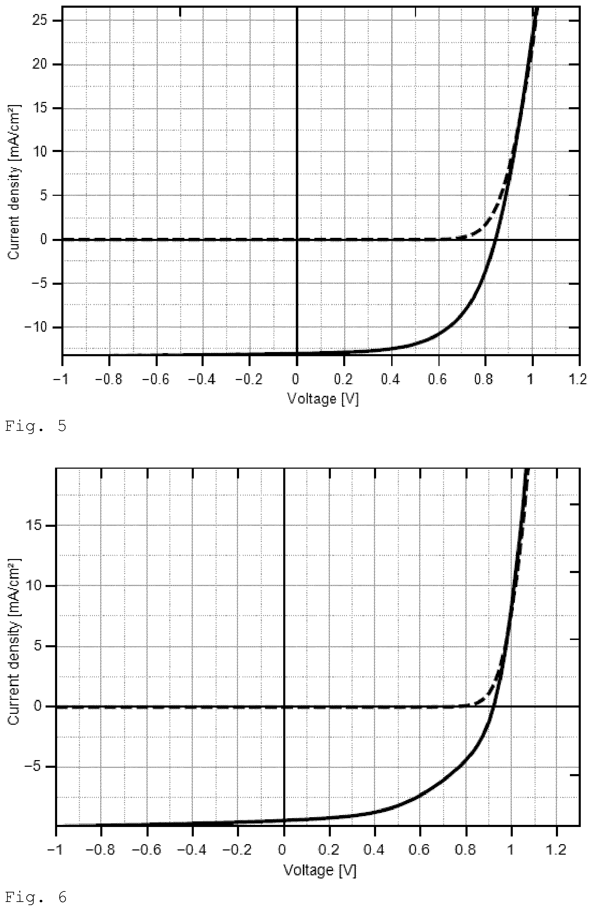

In einem weiteren Ausführungsbeispiel sind in den Fig. 4 und 5 graphisch die Messergebnisse für ein Bauelement 1 mit einer photoaktiven Schicht 5 mit einem anderen Donor-Akzeptorsystem dargestellt, wobei die photoaktive Schicht 5 eine Schichtdicke von 30 nm aufweist. Die Abscheidung der photoaktiven Schicht 5 erfolgte bei einer Substrattemperatur von 70°C. Die Fig. 4 zeigt die Strom-Spannungskennlinie eines Bauelements 1 mit einem Donor-Akzeptorsystem und die Fig. 5 eine Strom-Spannungskennlinie für ein Bauelement mit einer photoaktiven Schicht enthaltend das Donor-Akzeptorsystem sowie Verbindung (I). Die photoaktive Schicht 5 der Bauelemente unterscheidet sich hierbei nur hinsichtlich der Beimischung der Verbindung (I). Dabei zeigt sich ein durch die Beimischung der Verbindung (I) bedingter Anstieg des Füllfaktors (FF) von 48,8% auf 65,7%.

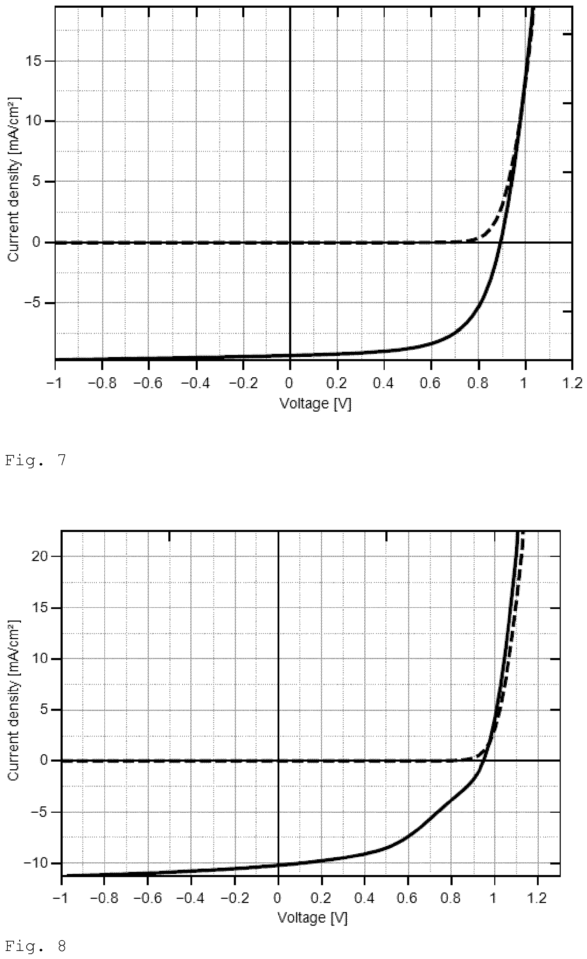

In einem weiteren Ausführungsbeispiel sind in den Fig. 6 und 7 graphisch die Messergebnisse für ein Bauelement 1 mit einer photoaktiven Schicht 5 mit einem dritten Donor-Akzeptorsystem dargestellt, wobei die photoaktive Schicht 5 eine Schichtdicke von 30 nm aufweist. Die Abscheidung der photoaktiven Schicht 5 erfolgte bei einer Substrattemperatur von 70°C. Die Fig. 6 zeigt die Strom-Spannungskennlinie eines Bauelements 1 mit einem Donor-Akzeptorsystem und die Fig. 7 eine Strom-Spannungskennlinie für ein Bauelement mit einer photoaktiven Schicht enthaltend das Donor-Akzeptorsystem sowie Verbindung (I). Die photoaktive Schicht 5 der Bauelemente unterscheidet sich hierbei nur hinsichtlich der Beimischung der Verbindung (I). Dabei zeigt sich ein durch die Beimischung der Verbindung (I) bedingter Anstieg des Füllfaktors (FF) von 50,7% auf 62,7%.

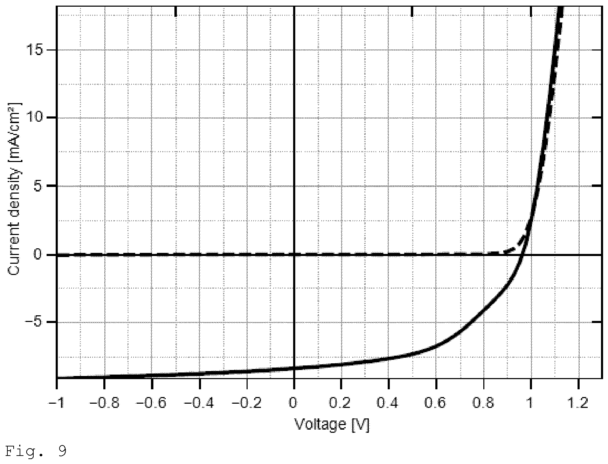

In einem weiteren Ausführungsbeispiel sind in den Fig. 8 und 9 graphisch die Messergebnisse für ein Bauelement 1 mit einer photoaktiven Schicht 5 mit einem Donor-Akzeptorsystem dargestellt, wobei die photoaktive Schicht 5 eine Schichtdicke von 30 nm aufweist. Die Abscheidung der photoaktiven Schicht 5 erfolgte bei einer Substrattemperatur von 70°C. Die Fig. 8 zeigt die Strom-Spannungskennlinie eines Bauelements 1 mit einem Donor-Akzeptorsystem und die Fig. 9 eine Strom-Spannungskennlinie für ein Bauelement mit einer photoaktiven Schicht enthaltend das Donor-Akzeptorsystem sowie Verbindung (II). Die photoaktive Schicht 5 der Bauelemente unterscheidet sich hierbei nur hinsichtlich der Beimischung der Verbindung (II). Dabei zeigt sich ein durch die Beimischung der Verbindung (II) bedingter Anstieg des Füllfaktors (FF) von 46% auf 50,6%.

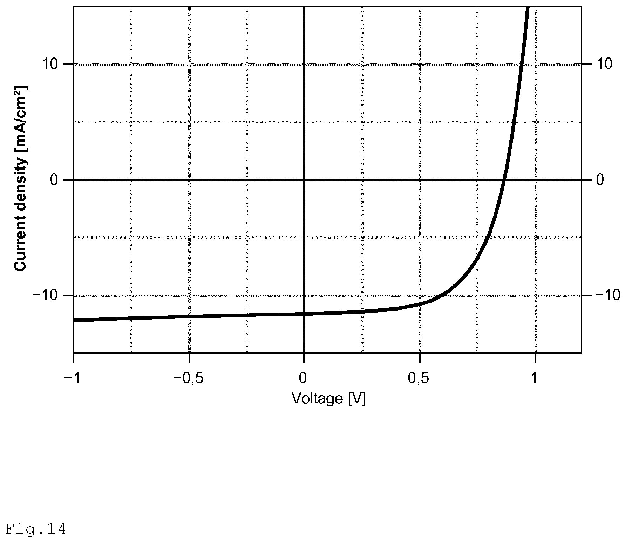

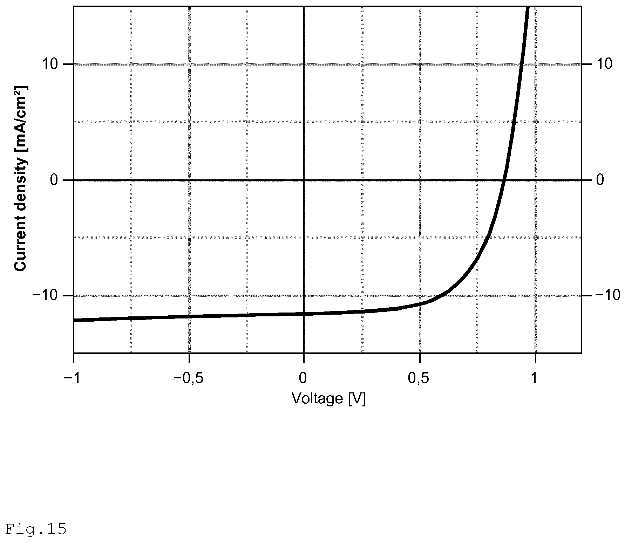

In einem weiteren Ausführungsbeispiel sind in den Fig. 14 und 15 graphisch die Messergebnisse für ein weiteres Bauelement 1 mit einer photoaktiven Schicht 5 mit einem Donor-Akzeptorsystem dargestellt, wobei die photoaktive Schicht 5 eine Schichtdicke von 30 nm aufweist. Die Abscheidung der photoaktiven Schicht 5 erfolgte bei einer Substrattemperatur von 70°C. Die Fig. 14 zeigt die Strom-Spannungskennlinie eines Bauelements 1 mit einem Donor-Akzeptorsystem und die Fig. 15 eine Strom-Spannungskennlinie für ein Bauelement mit einer photoaktiven Schicht enthaltend das Donor-Akzeptorsystem sowie Verbindung (III). Die photoaktive Schicht 5 der Bauelemente unterscheidet sich hierbei nur hinsichtlich der Beimischung der Verbindung (III). Dabei zeigt sich ein durch die Beimischung der Verbindung (III) bedingter Anstieg des Füllfaktors (FF) von 60,0% auf 65,2%.

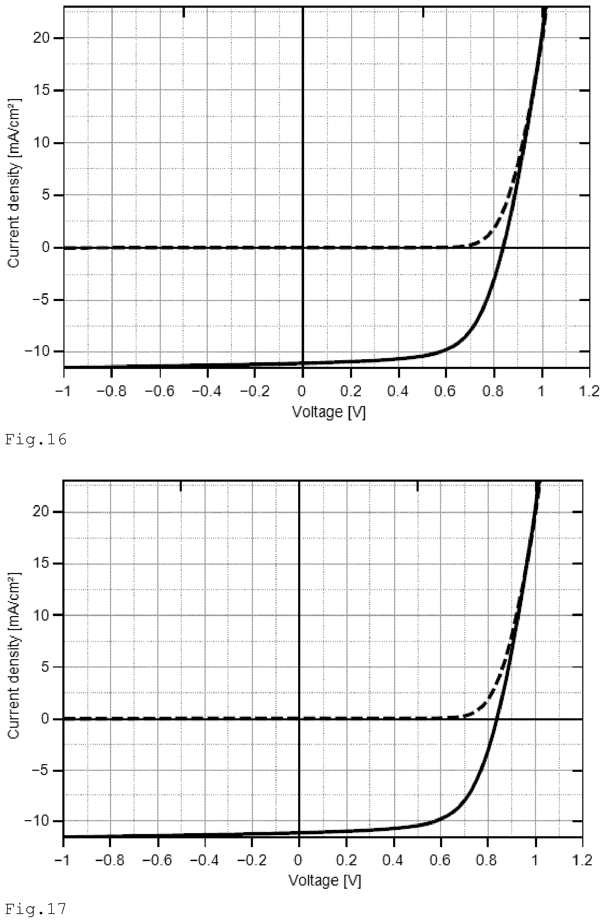

In einem weiteren Ausführungsbeispiel sind in den Fig. 16 und 17 graphisch die Messergebnisse für ein Bauelement 1 mit einer photoaktiven Schicht 5 mit einem Donor-Akzeptorsystem dargestellt, wobei die photoaktive Schicht 5 eine Schichtdicke von 30 nm aufweist. Die Abscheidung der photoaktiven Schicht 5 erfolgte bei Fig. 16 bei einer Substrattemperatur von 70°C und bei Fig. 17 bei Raumtemperatur. Die Fig. 16 zeigt die Strom-Spannungskennlinien eines Bauelements 1 mit einem Donor-Akzeptorsystem und die Fig. 17 eine Strom-Spannungskennlinien für ein Bauelement mit einer photoaktiven Schicht enthaltend das Donor-Akzeptorsystem sowie Verbindung (I). Die photoaktive Schicht 5 der Bauelemente unterscheidet sich hierbei hinsichtlich der Beimischung der Verbindung (I) sowie der Substrattemperatur bei der Abscheidung der photoaktiven Schicht 5. Dabei zeigt sich, dass die Füllfaktoren mit 64% (Fig.16) und 63,6% (Fig.17) nahezu gleich sind. Durch die Beimischung der Verbindung (I) kann somit bei geringeren Substrattemperaturen der gleiche Füllfaktor erreicht werden, wie bei geheizten Substraten ohne Beimischung. Durch die Beimischung können so vereinfachtere Bedingungen bei der Abscheidung erzielt werden.

In einem weiteren Ausführungsbeispiel weist das erfindungsgemäße Bauelement 1 eine photoaktive Schicht 5 auf, welche drei Materialien umfasst, wobei ein Donor- D1 und ein Akzeptormaterial A1 ein Donorakzeptorsystem ausbilden. Das Donormaterial D1 ist dabei beispielsweise ein Material aus der Klasse der Phthalocyanine, Perylenderivate, TPD-Derivate, Oligothiophene oder ein Material wie es in WO2006092134 A1, WO2011161262 oder WO2011161170A1 offenbart ist. Das Akzeptormaterial A1 ist dabei beispielsweise ein Fulleren oder Fullerenderivat (C60, C70, etc.). Die photoaktive Schicht 5 enthält weiterhin ein drittes Material, welches als weiteres Donormaterial D2 ausgebildet ist. Das dritte Material D2 beeinflusst dabei die Kristallisationsneigung des Donormaterials D1. In einer alternativen Ausgestaltung ist das dritte Material ein Akzeptormaterial A2, welches die Kristallisationsneigung des Akzeptormaterials A1 beeinflusst.

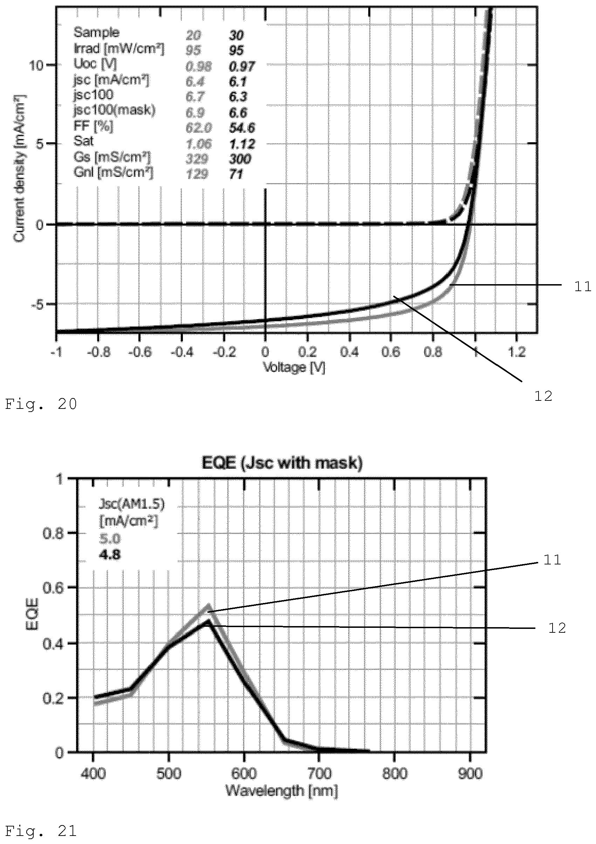

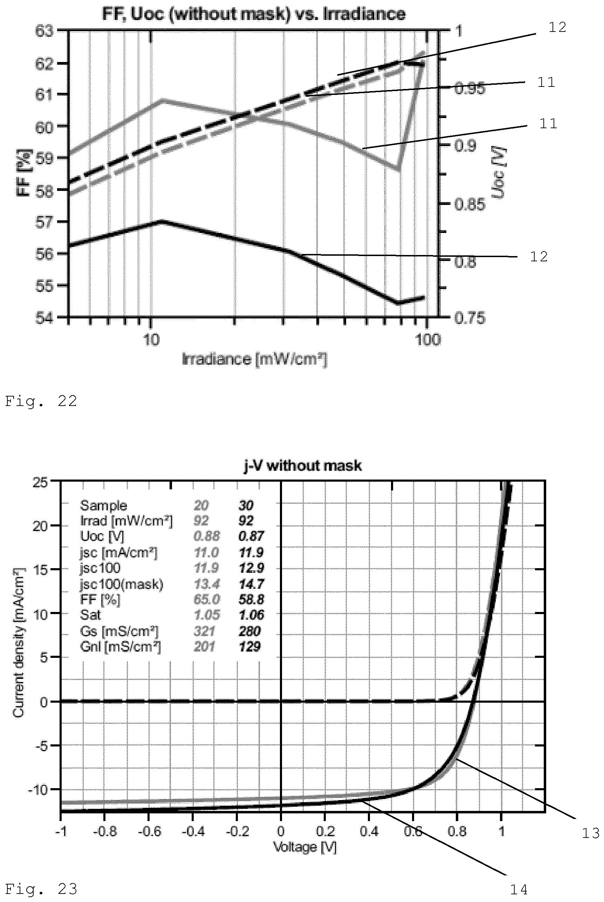

In einem weiteren Ausführungsbeispiel sind in den Fig. 20 bis 22 graphisch die Messergebnisse für ein Bauelement 1 mit einer photoaktiven Schicht 5 mit einem Donor-Akzeptorsystem dargestellt, wobei die photoaktive Schicht 5 eine 20nm (11) sowie eine 30nm (12) Schichtdicke aufweist. Dabei zeigt die Fig. 20 die Strom-Spannungskennlinien des Bauelements 1, die Fig. 21 die Darstellung der externen Quanteneffizienz und die Fig. 22 eine Auftragung des Füllfaktors (FF) sowie der Leerlaufspannung (U_{oc}) gegen die Beleuchtung.

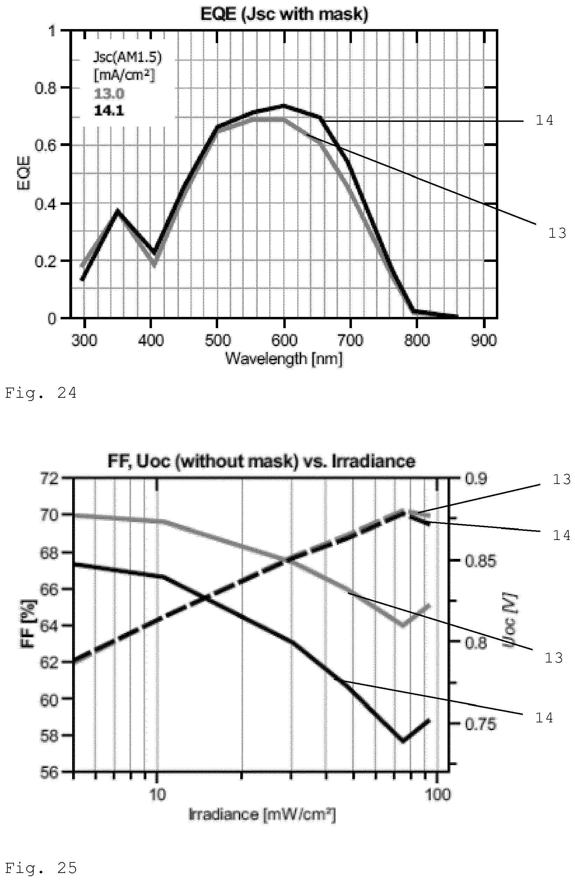

In einem weiteren Ausführungsbeispiel sind in den Fig. 23 bis 25 graphisch die Messergebnisse für ein Bauelement 1 mit einer photoaktiven Schicht 5 mit einem Donor-Akzeptorsystem mit weiteren Donor D2 als drittes Material dargestellt, wobei die photoaktive Schicht 5 eine 20nm (13) sowie eine 30nm (14) Schichtdicke aufweist und jeweils im Verhältnis 1:1:1 zugesetzt ist. Dabei zeigt die Fig. 23 die Strom-Spannungskennlinien des erfindungsgemäßen Bauelements 1, die Fig. 24 die Darstellung der externen Quanteneffizienz und die Fig. 25 eine Auftragung des Füllfaktors (FF) sowie der Leerlaufspannung (U_{oc}) gegen die Beleuchtung.

Aus dem Vergleich der Kennwerte Füllfaktor (FF) und erzeugtem Strom lässt sich ablesen, dass die Zugabe des dritten Materials einen wesentlichen Einfluss auf den erzeugten Strom hat. Besonders der Vergleich der Fig. 21 und Fig. 24 zeigt den Einfluss des dritten Materials auf die externe Quanteneffizienz, welche in der Fig. 24 deutlicher ausgeprägt ist im Vergleich zur Fig. 21.

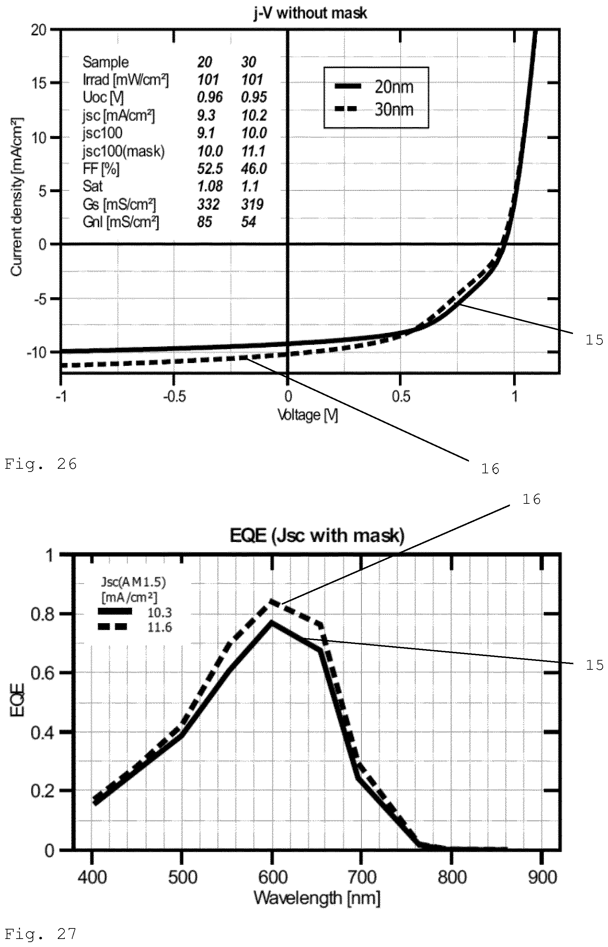

In einem weiteren Ausführungsbeispiel sind in den Fig. 26 und 27 graphisch die Messergebnisse für ein Bauelement 1 mit einer photoaktiven Schicht 5 mit einem Donor-Akzeptorsystem dargestellt, wobei die photoaktive Schicht 5 eine 20nm (15) sowie eine 30nm (16) Schichtdicke aufweist. Dabei zeigt die Fig. 26 die Strom-Spannungskennlinien des Bauelements 1 und die Fig. 27 die Darstellung der externen Quanteneffizienz.

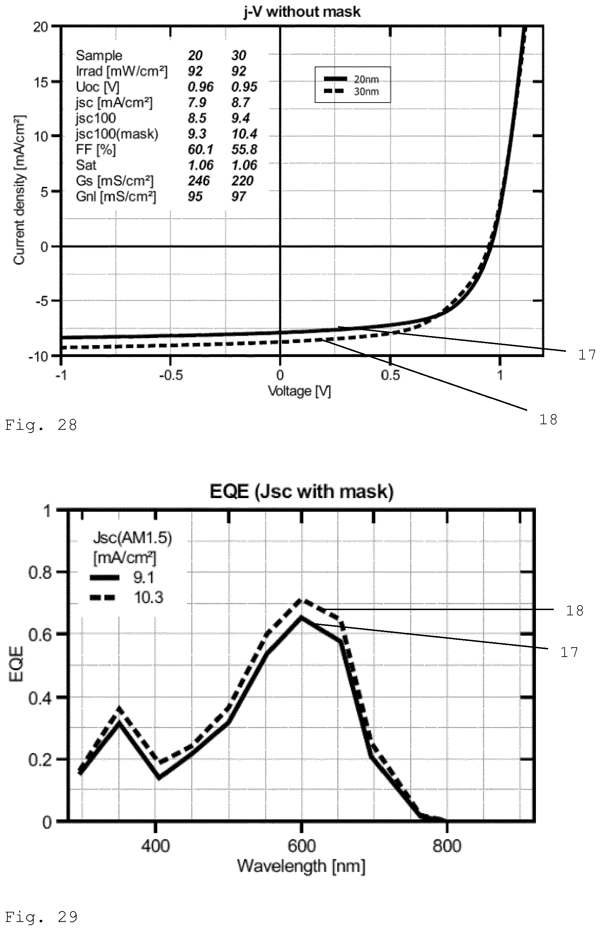

In einem weiteren Ausführungsbeispiel sind in den Fig. 28 und 29 graphisch die Messergebnisse für ein Bauelement 1 mit einer photoaktiven Schicht 5 mit einem Donor-Akzeptorsystem mit weiteren Donor D2 als drittes Material dargestellt, wobei die photoaktive Schicht 5 eine 20nm (17) sowie eine 30nm (18) Schichtdicke aufweist. Das Schicht 5 weist ein Verhältnis von Akzeptor:DonorD1:DonorD2 = 1:1:0,1 auf. Dabei zeigt die Fig. 28 die Strom-Spannungskennlinien des erfindungsgemäßen Bauelements 1, die Fig. 29 die Darstellung der externen Quanteneffizienz.

Aus dem Vergleich des Kennwerts Füllfaktor (FF) lässt sich ablesen, dass die Zugabe des dritten Materials Donor D2 einen wesentlichen Einfluss auf den Füllfaktor hat. Besonders der Vergleich der Fig. 26 und Fig. 28 zeigt den Einfluss des dritten Materials auf den Füllfaktor, welcher in der Fig. 28 höher ist im Vergleich zur Fig. 26.

In einem weiteren Ausführungsbeispiel ist in Fig. 30 ein Energieschema eines Bauelements mit einer photoaktiven Schicht mit einem Donor-Material, einem Akzeptormaterial und einem dritten Materialien dargestellt. Dabei kann der Fig. 30 die HOMO-Lage des Donor-Materials 10 und die LUMO-Lage des Donor-Materials 11 entnommen werden. Weiterhin zeigt die Fig. 30 die HOMO-Lage des Akzeptors 20 und die LUMO-Lage des Akzeptors 21. Des Weiteren zeigt die Fig. 30 die HOMO-Lage des dritten Materials 30 und die LUMO-Lage des dritten Materials 31. Wie der Fig. 30 zu entnehmen ist, weist dieses eine HOMO-Lage 30 betragsmäßig gleich oder über der der HOMO-Lage des Donormaterials sowie eine LUMO-Lage 31 betragsmäßig gleich oder unter der LUMO-Lage des Akzeptors, also zwischen der LUMO-Lage des Akzeptors und dem Vakuumniveau auf. Das Vakuumniveau der Energie ist mit Bezugszeichen 40 dargestellt.

### Optoelektronisches Bauelement

### Bezugszeichenliste

- 1: optoelektronisches Bauelement
- 2: Substrat
- 3: Elektrode
- 4: Ladungsträgertransportschicht (ETL oder HTL)
- 5: photoaktive Schicht
- 6: Ladungsträgertransportschicht (ETL oder HTL)
- 7: Gegenelektrode
- 10: HOMO-Lage des Donor-Materials
- 11: LUMO-Lage des Donor-Materials
- 20: HOMO-Lage des Akzeptor-Materials
- 21: LUMO-Lage des Akzeptor-Materials
- 30: HOMO-Lage des dritten Materials
- 31: LUMO-Lage des dritten Materials
- 40: Vakuumniveau der Energie

## Patentansprüche

1. Optoelektronisches Bauelement (1) umfassend zumindest eine photoaktiven Schicht(5), welche zwischen einer Elektrode (3) und einer Gegenelektrode (7) angeordnet ist, wobei die photoaktive Schicht (5) eine Mehrfach-Mischschicht enthaltend mindestens drei Materialien umfasst, wobei zumindest ein Material ein organisches Material aus kleinen Molekülen ist, wobei zumindest ein Material ein Donor und zumindest ein Material ein Akzeptor ist, wobei der Donor und der Akzeptor ein Donor-Akzeptor-System bilden und zumindest einem dritten Material, welches so ausgebildet ist, dass es die Kristallisationsneigung des Donors und/oder Akzeptors beeinflusst, **dadurch gekennzeichnet dass** das dritte Material aus der Gruppe der Kronenether ausgewählt ist.

2. Optoelektronisches Bauelement nach Anspruch 1, **dadurch gekennzeichnet, dass** das dritte Material ein Energieniveau aufweist, bei dem der Betrag des LUMO <= dem Betrag des LUMO des Akzeptors ist, und der Betrag des HOMO >= HOMO des Donors ist.

3. Optoelektronisches Bauelement nach einem der Ansprüche 1 oder 2, **dadurch gekennzeichnet, dass** das dritte Material ein Energieniveau aufweist, wobei der Betrag des LUMO des dritten Materials um 0,3 eV geringer als der Betrag des LUMO des Akzeptormaterials der photoaktiven Schicht (5) und/oder der Betrag des HOMO des dritten Materials um 0,3 eV größer des Betrags des Energieniveaus des HOMOs des Donatormaterials der photoaktiven Schicht (5) liegt.

4. Optoelektronisches Bauelement nach einem der vorhergehenden Ansprüche, **dadurch gekennzeichnet, dass** der Anteil des dritten Materials in der photoaktiven Schicht (5) 0,1 Gew.% < x < 30 Gew.%, bevorzugt 0,1 Gew.% < x < 20 Gew.%, besonders bevorzugt 0,1 Gew.% < x < 10 Gew.% ist.

5. Optoelektronisches Bauelement nach einem der vorhergehenden Ansprüche, **dadurch gekennzeichnet, dass** mindestens ein Donormaterial der photoaktiven Schicht (5) ein Oligomer ist.

6. Optoelektronisches Bauelement nach einem der vorhergehenden Ansprüche, **dadurch gekennzeichnet, dass** das dritte Material ein Oligomer ist.

7. Optoelektronisches Bauelement nach einem der vorhergehenden Ansprüche, umfassend das dritte Material zur Minimierung einer Kristallisation der Donator- und/oder Akzeptor-Phase aufgrund seiner Molekularstruktur.

8. Optoelektronisches Bauelement nach einem der vorhergehenden Ansprüche, umfassend das dritte Material zur Vermeidung einer Kristallisation von Donator und/oder Akzeptor.

9. Optoelektronisches Bauelement nach einem der vorhergehenden Ansprüche, umfassend das dritte Material, zur Ausbildung eines Gitterdefekts im Donor- und/oder Akzeptormaterial, aufgrund seiner molekularen Struktur.

10. Optoelektronisches Bauelement nach einem der vorhergehenden Ansprüche, umfassend das dritte Material, zur Einstellung eines Mindestabstandes zwischen dem Akzeptor und Donor, wobei das dritte Material gleichzeitig zur Phasenseparation des Akzeptors und Donors beiträgt.

11. Optoelektronisches Bauelement nach einem der vorhergehenden Ansprüche, umfassend das dritte Material, zur Förderung einer Kristallisation der Donator- und/oder Akzeptor-Phase, aufgrund seiner Molekularstruktur.

12. Optoelektronisches Bauelement nach einem der vorhergehenden Ansprüche, **dadurch gekennzeichnet, dass** das dritte Material in seiner Molekülstruktur einen ersten Bereich aufweist, welcher fullerenophil ausgebildet ist und einen zweiten Bereich auf, welcher fullerenophob ausgebildet ist, wobei der erste und zweite Bereich räumlich getrennt ausgebildet sind.

13. Optoelektronisches Bauelement nach einem der vorhergehenden Ansprüche , **dadurch gekennzeichnet, dass** die Kronenether ausgewählt sind aus einer Gruppe der allgemeinen Formel (Ia) oder (Ib): 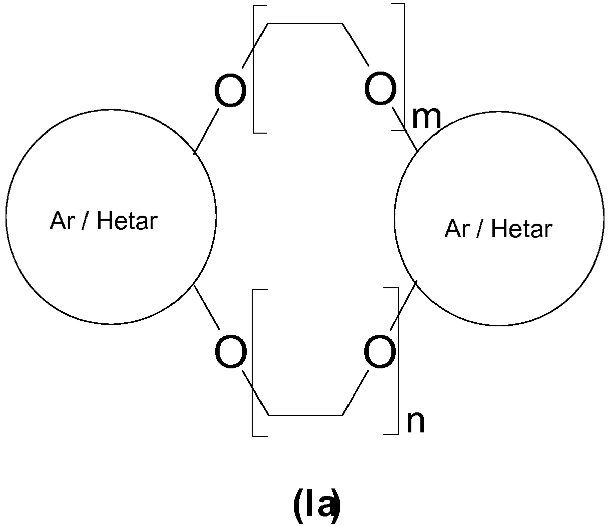 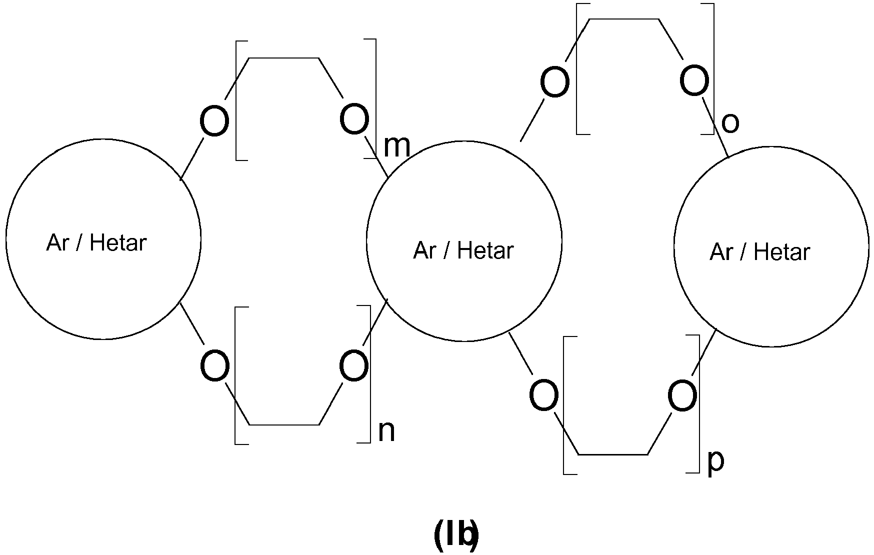
mit Ar = Phenyl, Biphenyl, Triphenyl, Naphthyl, Binaphthyl, 3-6 annelierte Phenylringe, Anthracenyl, Phenanthrenyl, Pyrenyl
Hetar = Thiophen, Pyrrol, Furan, Oxazol, Thiazol, Oxadiazol, Thiadiazol, Triazol, Pyridin, Pyrimidin, Pyrazin, Benzothiophene, Benzopyrrol, Benzofuran, Benzothiophen, Benzopyrrol, Benzofuran, Benzoxazol, Benzothiazol,Thienothiophene, Thienopyrrol, Thienofuran, 3-6 annelierte Heterocyclen, Dithienothiophen, Dithienopyrrol, Dithienobenzol, Dithienocyclopentadiene, Dipyrrolobenzol
Etherbrücken in 1,2-, 1,3- und 1,4-Verknüpfung am jeweiligen Phenylring (ortho, meta- und para-Position), Naphthylring, annelierten Phenylring sowie Heteroarylring und annelierten Heteroarylring.
m und n unabhängig voneinander 1,2,3,4,5,6
∘ und p unabhängig voneinander 0,1,2,3,4,5,6

14. Optoelektronisches Bauelement nach Anspruch 13 **dadurch gekennzeichnet, dass** die Kronenether Verbindungen der nachfolgenden Strukturen sind: 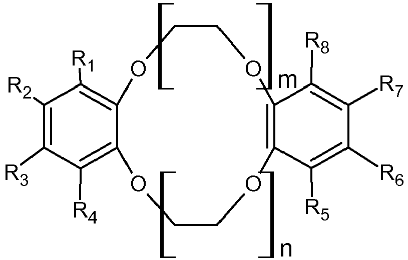 oder 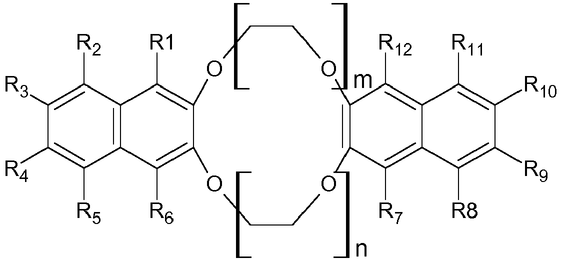 oder 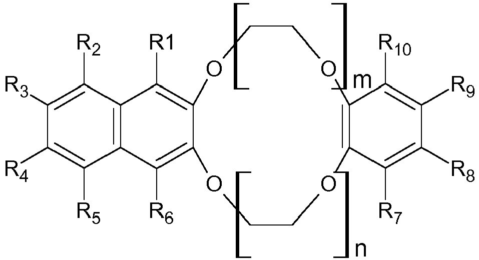 oder 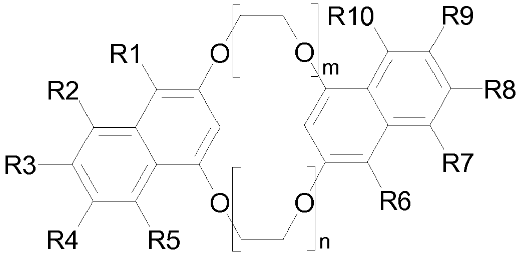 oder 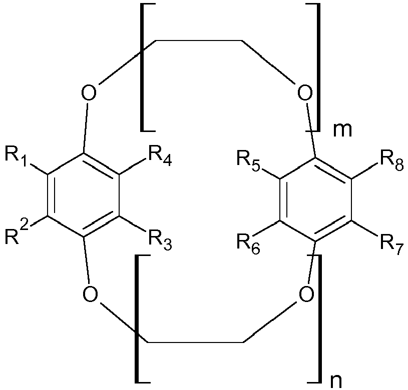 oder 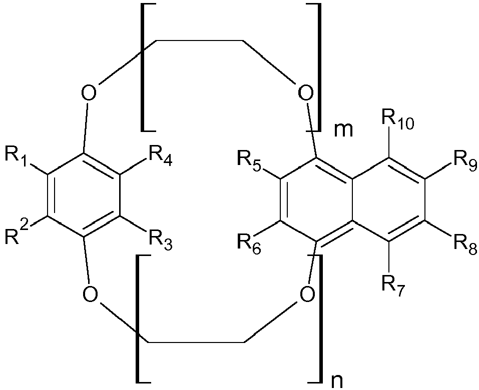 oder 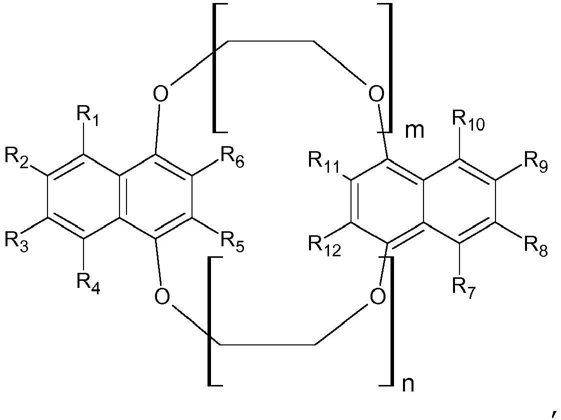
wobei jeweils gilt: n und m unabhängig voneinander ausgewählt aus 3, 4, oder 5, und
R₁, R₂, R₃, R₄, R₅, R₆, R₇, R₈, R₉, R₁₀, R₁₁ und R₁₂ unabhängig voneinander ausgewählt aus H, CH₃, C₂H₅, C₃H₇, C₄H₉, C₅H₁₁, C₆H₁₃, Isobutyl, CF₃, C₂F₅, C₃F₇, C₄F₉, C₅F₁₁, C₆F₁₃, OH, O-CH₃, CH₂-O-CH₃, CH₂-O-CH₂-CH₃, CN, Phenyl, Thiophen.

15. Optoelektronisches Bauelement nach einem der Ansprüche 1 bis 12,**dadurch gekennzeichnet, dass** die Kronenether die nachfolgende allgemeine Formel (II) aufweisen: 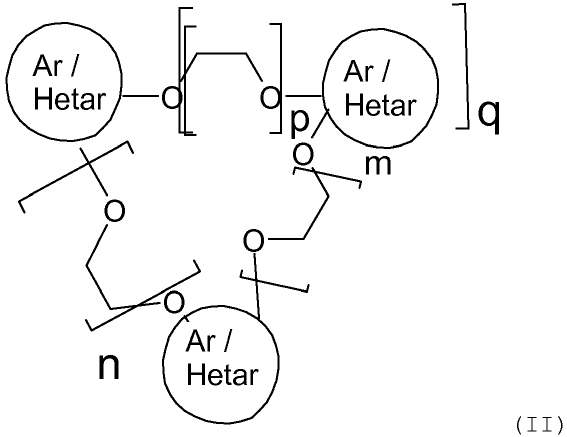
mit Ar = Phenyl, Biphenyl, Triphenyl, Naphthyl,Binaphthyl, 3-6 annelierte Phenylringe (Anthracenyl, Phenanthrenyl, Pyrenyl,...)
Hetar = Thiophen, Pyrrol, Furan, Oxazol, Thiazol, Oxadiazol, Thiadiazol, Triazol, Pyridin, Pyrimidin, Pyrazin, Benzothiophene, Benzopyrrol, Benzofuran, Benzothiophen, Benzopyrrol, Benzofuran, Benzoxazol, Benzothiazol,Thienothiophene, Thienopyrrol, Thienofuran, 3-6 annelierte Heterocyclen, Dithienothiophen, Dithienopyrrol, Dithienobenzol, Dithienocyclopentadiene, Dipyrrolobenzol
Etherbrücken in 1,2-, 1,3- und 1,4-Verknüpfung am jeweiligen Phenylring (ortho, meta- und para-Position), Naphthylring, annelierten Phenylring sowie Heteroarylring und annelierten Heteroarylring.
m und n unabhängig voneinander 1,2,3,4,5,6
p und q unabhängig voneinander 1,2,3,4,5,6

16. Verwendung von Kronenethern nach einem der Ansprüche 1 bis 15 in photoaktiven Schichten optoelektronischer Bauelemente.

17. Optoelektronisches Bauelement nach einem der vorhergehenden Ansprüche, **dadurch gekennzeichnet, dass** das optoelektronische Bauelement (1) eine organische Solarzelle ist.

## Claims

1. Optoelectronic component (1) comprising at least one photoactive layer (5) disposed between an electrode (3) and a counterelectrode (7), wherein the photoactive layer (5) comprises a mixed multiple layer containing at least three materials, wherein at least one material is an organic material composed of small molecules, wherein at least one material is a donor and at least one material is an acceptor, wherein the donor and the acceptor form a donor-acceptor system and at least one third material which is set up so as to affect the propensity of the donor and/or acceptor to crystallize, **characterized in that** the third materials is selected from the group of the crown ethers.

2. Optoelectronic component according to Claim 1, **characterized in that** the third material has an energy level at which the magnitude of the LUMO <= the magnitude of the LUMO of the acceptor, and the magnitude of the HOMO >= HOMO of the donor.

3. Optoelectronic component according to either of Claims 1 and 2, **characterized in that** the third material has an energy level where the magnitude of the LUMO of the third material is 0.3 eV lower than the magnitude of the LUMO of the acceptor material of the photoactive layer (5) and/or the magnitude of the HOMO of the third material is 0.3 eV greater than the magnitude of the energy level of the HOMO of the donor material of the photoactive layer (5).

4. Optoelectronic component according to any of the preceding claims, **characterized in that** the proportion of the third material in the photoactive layer (5) is 0.1% by weight < x < 30% by weight, preferably 0.1% by weight < x < 20% by weight, more preferably 0.1% by weight < x < 10% by weight.

5. Optoelectronic component according to any of the preceding claims, **characterized in that** at least one donor material in the photoactive layer (5) is an oligomer.

6. Optoelectronic component according to any of the preceding claims, **characterized in that** the third material is an oligomer.

7. Optoelectronic component according to any of the preceding claims, comprising the third material for minimizing crystallization of the donor and/or acceptor phase, because of its molecular structure.

8. Optoelectronic component according to any of the preceding claims, comprising the third material for preventing crystallization of donor and/or acceptor.

9. Optoelectronic component according to any of the preceding claims, comprising the third material for causing a lattice defect in the donor and/or acceptor material, because of its molecular structure.

10. Optoelectronic component according to any of the preceding claims, comprising the third material for establishing a minimum separation between the acceptor and donor, wherein the third material simultaneously contributes to the phase separation of the acceptor and donor.

11. Optoelectronic component according to any of the preceding claims, comprising the third material for promoting crystallization of the donor and/or acceptor phase, because of its molecular structure.

12. Optoelectronic component according to any of the preceding claims, **characterized in that** the third material, in its molecular structure, has a first region set up to be fullerenophilic and a second region set up to be fullerenophobic, wherein the first and second regions are set up with spatial separation.

13. Optoelectronic component according to any of the preceding claims, **characterized in that** the crown ethers are selected from a group of the general formula (Ia) or (Ib) 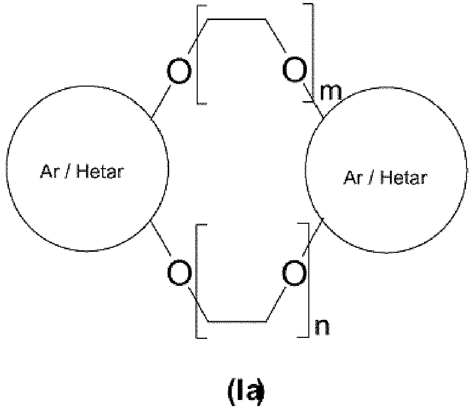 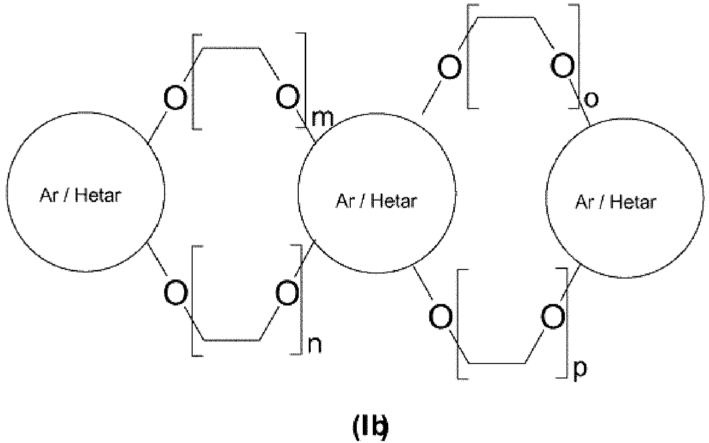
with Ar = phenyl, biphenyl, triphenyl, naphthyl, binaphthyl, 3-6 fused phenyl rings, anthracenyl, phenanthrenyl, pyrenyl
Hetar = thiophene, pyrrole, furan, oxazole, thiazole, oxadiazole, thiadiazole, triazole, pyridine, pyrimidine, pyrazine, benzothiophenes, benzopyrrole, benzofuran, benzothiophene, benzo-pyrrole, benzofuran, benzoxazole, benzothiazole, thienothiophenes, thienopyrrole, thienofuran, 3-6 fused heterocycles, dithienothiophene, dithieno-pyrrole, dithienobenzene, dithienocyclopentadienes, dipyrrolobenzene,
ether bridges joined in 1,2, 1,3 and 1,4 positions on the particular phenyl ring (ortho, meta and para positions), naphthyl ring, fused phenyl ring, and heteroaryl ring and fused heteroaryl ring,
m and n are each independently 1, 2, 3, 4, 5, 6,
o and p are each independently 0, 1, 2, 3, 4, 5, 6.

14. Optoelectronic component according to Claim 13, **characterized in that** the crown ethers are compounds of the following structures: 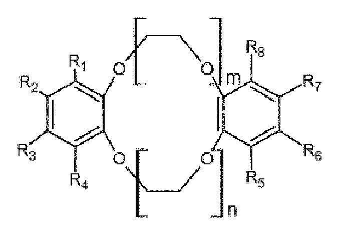 or 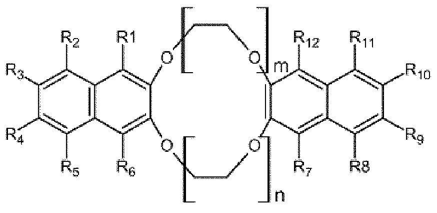 or 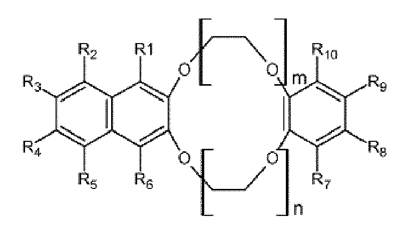 or 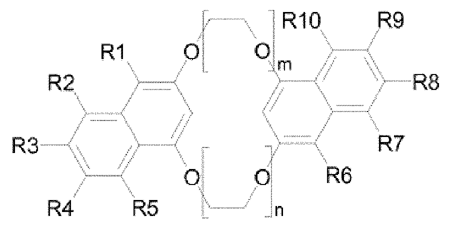 or 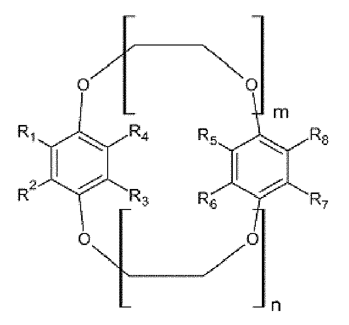 or 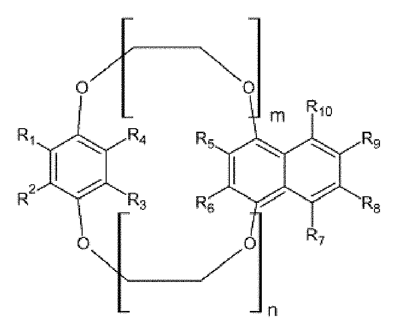 or 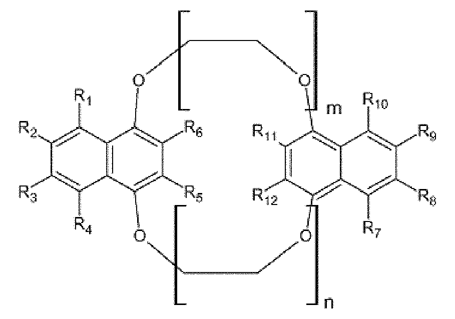
where in each case: n and m are each independently selected from 3, 4 and 5, and
R₁, R₂, R₃, R₄, R₅, R₆, R₇, R₈, R₉, R₁₀, R₁₁ and R₁₂ are each independently selected from H, CH₃, C₂H₅, C₃H₇, C₄H₉, C₅H₁₁, C₆H₁₃, isobutyl, CF₃, C₂F₅, C₃F₇, C₄F₉, C₅F₁₁, C₆F₁₃, OH, O-CH₃, CH₂-O-CH₃, CH₂-O-CH₂-CH₃, CN, phenyl, thiophene.

15. Optoelectronic component according to any of Claims 1 to 12, **characterized in that** the crown ethers have the following general formula (II): 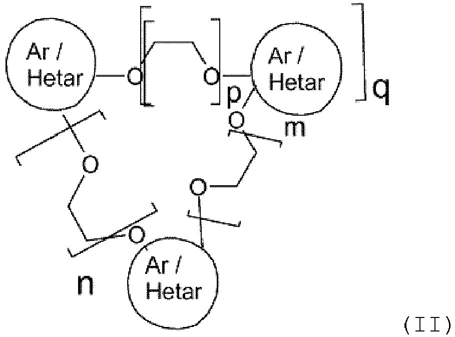
with Ar = phenyl, biphenyl, triphenyl, naphthyl, binaphthyl, 3-6 fused phenyl rings (anthracenyl, phenanthrenyl, pyrenyl, ...),
Hetar = thiophene, pyrrole, furan, oxazole, thiazole, oxadiazole, thiadiazole, triazole, pyridine, pyrimidine, pyrazine, benzothiophenes, benzopyrrole, benzofuran, benzothiophene, benzo-pyrrole, benzofuran, benzoxazole, benzothiazole, thienothiophenes, thienopyrrole, thienofuran, 3-6 fused heterocycles, dithienothiophene, dithieno-pyrrole, dithienobenzene, dithienocyclopentadienes, dipyrrolobenzene,
ether bridges joined in 1,2, 1,3 and 1,4 positions on the particular phenyl ring (ortho, meta and para positions), naphthyl ring, fused phenyl ring, and heteroaryl ring and fused heteroaryl ring,
m and n are each independently 1, 2, 3, 4, 5, 6,
p and q are each independently 1, 2, 3, 4, 5, 6.

16. Use of crown ethers according to any of Claims 1 to 15 in photoactive layers of optoelectronic components.

17. Optoelectronic component according to any of the preceding claims, **characterized in that** the optoelectronic component (1) is an organic solar cell.

## Revendications

1. Composant optoélectronique (1) comprenant au moins une couche photoactive (5) qui est disposée entre une électrode (3) et une contre-électrode (7), la couche photoactive (5) comprenant une couche multi-mixte contenant au moins trois matériaux, au moins un matériau étant un matériau organique constitué de petites molécules, au moins un matériau étant un donneur et au moins un matériau étant un accepteur, le donneur et l'accepteur formant un système donneur-accepteur et au moins un troisième matériau qui est de nature telle qu'il influe sur le tendance à la cristallisation du donneur et/ou de l'accepteur, **caractérisé en ce que** le troisième matériaux est choisi dans le groupe des éthers-couronnes.

2. Composant optoélectronique selon la revendication 1, **caractérisé en ce que** le troisième matériau présente un niveau d'énergie pour lequel la valeur de la LUMO est ≤ la valeur de la LUMO de l'accepteur, et la valeur de l'HOMO est ≥ HOMO du donneur.

3. Composant optoélectronique selon l'une quelconque des revendications 1 et 2, **caractérisé en ce que** le troisième matériau présente un niveau d'énergie pour lequel la valeur de la LUMO du troisième matériau est inférieure de 0,3 eV à la valeur de la LUMO du matériau accepteur de la couche photoactive (5) et/ou la valeur de l'HOMO du troisième matériau est supérieure de 0,3 eV à la valeur du niveau d'énergie de l'HOMO du matériau donneur de la couche photoactive (5).

4. Composant optoélectronique selon l'une quelconque des revendications précédentes, **caractérisé en ce que** la proportion du troisième matériau dans la couche photoactive (5) est 0,1 % en poids < x < 30 % en poids, de préférence 0,1 % en poids < x < 20 % en poids, de façon particulièrement préférée 0,1 % en poids < x < 10 % en poids.

5. Composant optoélectronique selon l'une quelconque des revendications précédentes, **caractérisé en ce qu'**au moins un matériau donneur de la couche photoactive (5) est un oligomère.

6. Composant optoélectronique selon l'une quelconque des revendications précédentes, **caractérisé en ce que** le troisième matériau est un oligomère.

7. Composant optoélectronique selon l'une quelconque des revendications précédentes, comprenant le troisième matériau pour la réduction au minimum d'une cristallisation de la phase du donneur et/ou de la phase de l'accepteur, en raison de sa structure moléculaire.

8. Composant optoélectronique selon l'une quelconque des revendications précédentes, comprenant le troisième matériau pour éviter une cristallisation du donneur et/ou de l'accepteur.

9. Composant optoélectronique selon l'une quelconque des revendications précédentes, comprenant le troisième matériau pour la formation d'un défaut de réseau dans le matériau donneur et/ou le matériau accepteur, en raison de sa structure moléculaire.

10. Composant optoélectronique selon l'une quelconque des revendications précédentes, comprenant le troisième matériau pour l'établissement d'une distance minimale entre l'accepteur et le donneur, le troisième matériau contribuant en même temps à la séparation de phases de l'accepteur et du donneur.

11. Composant optoélectronique selon l'une quelconque des revendications précédentes, comprenant le troisième matériau pour favoriser une cristallisation de la phase du donneur et/ou de l'accepteur, en raison de sa structure moléculaire.

12. Composant optoélectronique selon l'une quelconque des revendications précédentes, **caractérisé en ce que** le troisième matériau comporte dans sa structure moléculaire une première zone qui a une configuration fullerénophile et une deuxième zone qui a une configuration fullerénophobe, les première et deuxième zones étant développées séparément dans l'espace.

13. Composant optoélectronique selon l'une quelconque des revendications précédentes, **caractérisé en ce que** les éthers-couronnes sont choisis dans un groupe de formule générale (Ia) ou (Ib) : 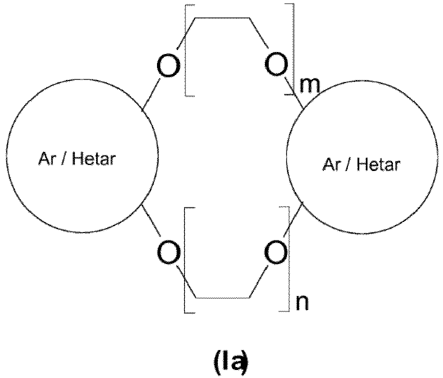 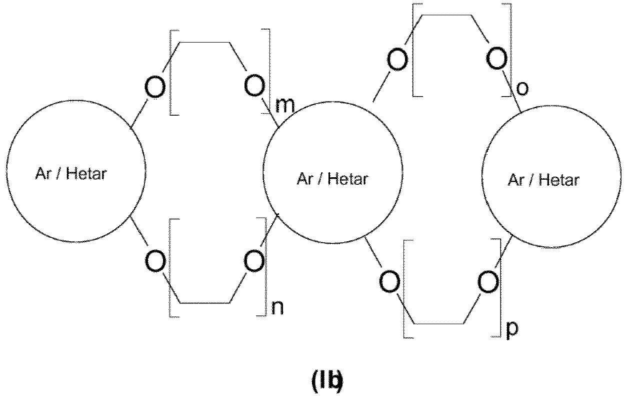
où Ar = phényle, biphényle, triphényle, naphtyle, binaphtyle, 3-6 cycles phényle condensés, anthracényle, phénanthrényle, pyrényle
Hetar = thiophène, pyrrole, furane, oxazole, thiazole, oxadiazole, thiadiazole, triazole, pyridine, pyrimidine, pyrazine, benzothiophènes, benzopyrrole, benzofurane, benzothiophène, benzopyrrole, benzofurane, benzoxazole, benzothiazole, thiénothiophènes, thiénopyrrole, thiénofurane, 3-6 hétérocycles condensés, dithiénothiophène, dithiénopyrrole, dithiénobenzène, dithiénocyclopentadiènes, dipyrrolobenzène
ponts éther en liaison 1,2, 1,3 et 1,4 au cycle phényle (position ortho, méta et para), cycle naphtyle, cycle phényle condensé, ainsi que cycle hétéroaryle et cycle hétéroaryle condensé, respectif,
m et n représentent indépendamment l'un de l'autre 1, 2, 3, 4, 5, 6
o et p représentent indépendamment l'un de l'autre 0, 1, 2, 3, 4, 5, 6.

14. Composant optoélectronique selon la revendication 13, **caractérisé en ce que** les éthers-couronnes sont des composés de structures suivantes : 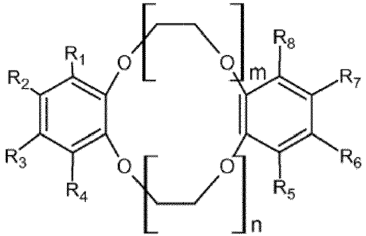 ou 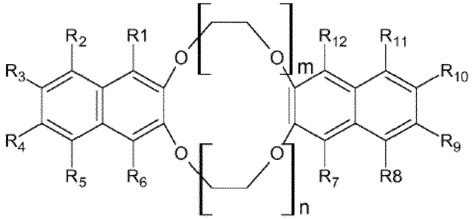 ou 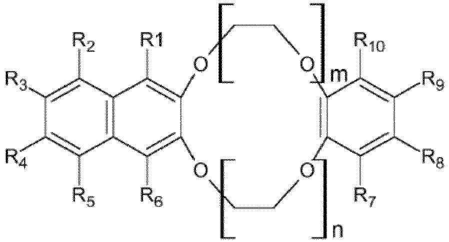 ou 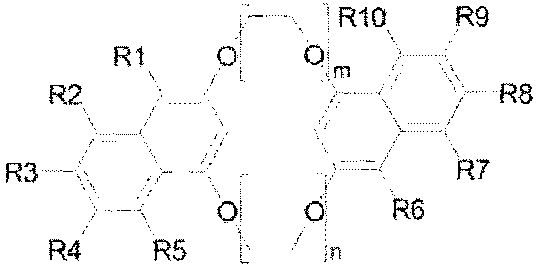 ou 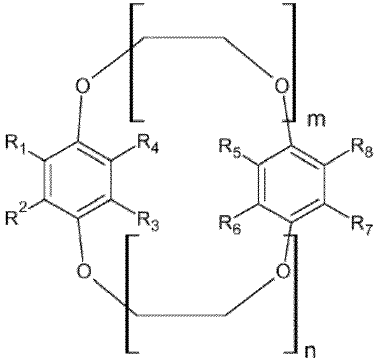 ou 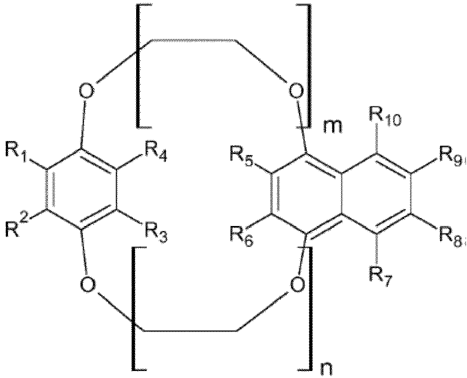 ou 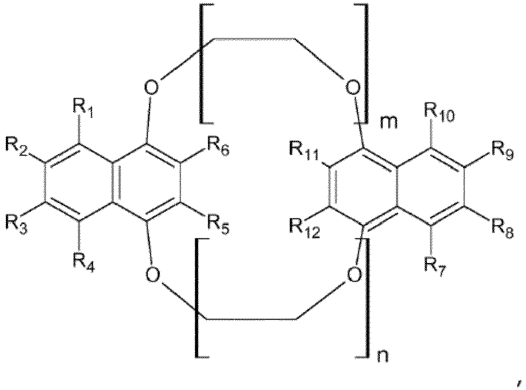
étant entendu qu'en chaque cas : n et m sont choisis indépendamment l'un de l'autre parmi 3, 4 ou 5, et
R₁, R₂, R₃, R₄, R₅, R₆, R₇, R₈, R₉, R₁₀, R₁₁ et R₁₂ sont choisis indépendamment les uns des autres parmi H, CH₃, C₂H₅, C₃H₇, C₄H₉, C₅H₁₁, C₆H₁₃, isobutyle, CF₃, C₂F₅, C₃F₇, C₄F₉, C₅F₁₁, C₆F₁₃, OH, O-CH₃, CH₂-O-CH₃, CH₂-O-CH₂-CH₃, CN, phényle, thiophène.

15. Composant optoélectronique selon l'une quelconque des revendications 1 à 12, **caractérisé en ce que** les éthers-couronnes présentent la formule générale (II) suivante : 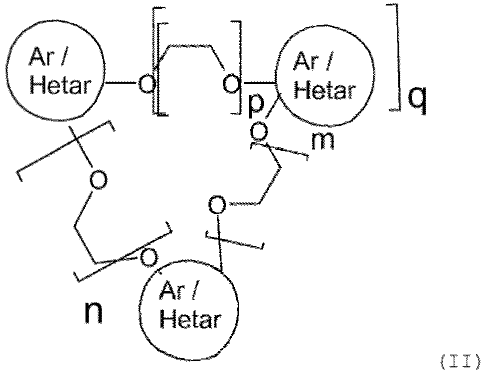
où Ar = phényle, biphényle, triphényle, naphtyle, binaphtyle, 3-6 cycles phényle condensés (anthracényle, phénanthrényle, pyrényle,...)
Hetar = thiophène, pyrrole, furane, oxazole, thiazole, oxadiazole, thiadiazole, triazole, pyridine, pyrimidine, pyrazine, benzothiophènes, benzopyrrole, benzofurane, benzothiophène, benzopyrrole, benzofurane, benzoxazole, benzothiazole, thiénothiophènes, thiénopyrrole, thiénofurane, 3-6 hétérocycles condensés, dithiénothiophène, dithiénopyrrole, dithiénobenzène, dithiénocyclopentadiènes, dipyrrolobenzène
ponts éther en liaison 1,2, 1,3 et 1,4 au cycle phényle (position ortho, méta et para), cycle naphtyle, cycle phényle condensé, ainsi que cycle hétéroaryle et cycle hétéroaryle condensé, respectif,
m et n représentent indépendamment l'un de l'autre 1, 2, 3, 4, 5, 6
p et q représentent indépendamment l'un de l'autre 1, 2, 3, 4, 5, 6.

16. Utilisation d'éthers-couronnes selon l'une quelconque des revendications 1 à 15 dans des couches photoactives de composants optoélectroniques.

17. Composant optoélectronique selon l'une quelconque des revendications précédentes, **caractérisé en ce que** le composant optoélectronique (1) est une cellule solaire organique.
